# EUROPEAN PATENT APPLICATION

(11) **EP 4 123 729 A1**
(43) Date of publication of application: **25.01.2023**
(21) Application number: 21771349.4
(22) Date of filing: 03.03.2021
(51) Int. Cl.: H01L 31/107, H01L 27/146, G01S 7/481

(54) **LIGHT-RECEIVING ELEMENT AND RANGING SYSTEM**

(30) Priority: 16.03.2020 JP 2020044968
(71) Applicant: Sony Semiconductor Solutions Corporation, Atsugi-shi Kanagawa 243-0014 (JP)
(72) Inventor: SHIMADA Shohei, Atsugi-shi, Kanagawa 243-0014 (JP); YOSHIDA Satoru, Atsugi-shi, Kanagawa 243-0014 (JP)
(74) Representative: Müller Hoffmann & Partner
(86) International application number: PCT/JP2021/008077
(87) International publication number: WO 2021/187096

(57) **Abstract**

The present technology relates to a light receiving element and a distance measuring system capable of achieving high PDE while preventing edge break.

A light receiving element includes a pixel in which a multiplication region is formed in a region where a first semiconductor region of a first conductivity type and a second semiconductor region of a second conductivity type opposite to the first semiconductor region are joined, and a planar region of the second semiconductor region formed at a position closer to a light receiving surface than the first semiconductor region is formed to be larger. The present technology can be applied to, for example, a distance measuring system or the like that detects a distance to a subject in a depth direction.

## Description

### TECHNICAL FIELD

The present technology relates to a light receiving element and a distance measuring system, and more particularly to a light receiving element and a distance measuring system capable of achieving high PDE while preventing edge break.

### BACKGROUND ART

In recent years, a distance measuring sensor that measures a distance by a Time-of-Flight (ToF) method has attracted attention. Examples of the distance measuring sensor include a distance measuring sensor using a single photon avalanche diode (SPAD) as a light receiving pixel. In the SPAD, avalanche amplification occurs when one photon enters a PN junction region of a high electric field in a state where a voltage larger than a breakdown voltage (hereinafter referred to as excess bias (ExcessBias)) is applied. By detecting the timing at which the current instantaneously flows at that time, the distance can be measured with high accuracy.

For example, Patent Document 1 discloses a pixel structure in which an area of a p-type semiconductor region of a multiplication region including an n-type semiconductor region and a p-type semiconductor region is formed smaller than an n-type semiconductor region in order to reduce a strong electric field (edge break) at an end portion of the multiplication region where avalanche amplification occurs.

### CITATION LIST

### PATENT DOCUMENT

Patent Document 1: WO 2018/074530

### SUMMARY OF THE INVENTION

### PROBLEMS TO BE SOLVED BY THE INVENTION

However, the pixel structure of Patent Document 1 has high internal resistance, requires a large excessive bias, and has room for improvement.

The present technology has been made in view of such a situation, and an object thereof is to make it possible to achieve high photon detection efficiency (PDE) while preventing edge break.

### SOLUTIONS TO PROBLEMS

A light receiving element according to a first aspect of the present technology includes a pixel in which a multiplication region is formed in a region where a first semiconductor region of a first conductivity type and a second semiconductor region of a second conductivity type opposite to the first semiconductor region are joined, and a planar region of the second semiconductor region formed at a position closer to a light receiving surface than the first semiconductor region is formed to be larger.

A distance measuring system according to a second aspect of the present technology includes a lighting device that emits irradiation light, and a light receiving element that receives reflected light obtained by reflecting the irradiation light by a subject, in which the light receiving element includes a pixel in which a multiplication region is formed in a region where a first semiconductor region of a first conductivity type and a second semiconductor region of a second conductivity type opposite to the first semiconductor region are joined, and a planar region of the second semiconductor region formed at a position closer to a light receiving surface than the first semiconductor region is formed to be larger.

In the first and second aspects of the present technology, a multiplication region is formed in a region where a first semiconductor region of a first conductivity type and a second semiconductor region of a second conductivity type opposite to the first semiconductor region are joined, and a planar region of the second semiconductor region formed at a position closer to a light receiving surface than the first semiconductor region is formed to be larger.

The light receiving element and the distance measuring system may be independent devices, or may be modules incorporated in other devices.

### BRIEF DESCRIPTION OF DRAWINGS

Fig. 1 is a diagram illustrating a circuit configuration example of a pixel using a SPAD.
Fig. 2 is a graph illustrating an operation of the pixel in Fig. 1.
Fig. 3 is a view illustrating a first pixel structure of a pixel using the SPAD.
Fig. 4 is a diagram illustrating operations and effects of the first pixel structure.
Fig. 5 is a view illustrating the operations and effects of the first pixel structure.
Fig. 6 is a cross-sectional view illustrating a first modification example of the pixel according to the first pixel structure.
Fig. 7 is a cross-sectional view illustrating a second modification example of the pixel according to the first pixel structure.
Fig. 8 is a plan view of pixels according to the first pixel structure.
Fig. 9 is a plan view illustrating a third modification example of the pixel according to the first pixel structure.
Fig. 10 is a cross-sectional view illustrating a second pixel structure of the pixel using the SPAD.
Fig. 11 is a cross-sectional view illustrating a modification example of the pixel according to the second pixel structure.
Fig. 12 is a cross-sectional view illustrating a third pixel structure of the pixel using the SPAD.
Fig. 13 is a cross-sectional view illustrating a fourth pixel structure of the pixel using the SPAD.
Fig. 14 is a cross-sectional view illustrating a fifth pixel structure of the pixel using the SPAD.
Fig. 15 is a cross-sectional view illustrating a sixth pixel structure of the pixel using the SPAD.
Fig. 16 is a view illustrating a seventh pixel structure of the pixel using the SPAD.
Fig. 17 is a view illustrating a flow of electrons in a semiconductor region.
Fig. 18 is an enlarged view of a cathode contact peripheral region in Fig. 17.
Fig. 19 is a view illustrating depths in a substrate thickness direction of a separation layer and a low-concentration n-type semiconductor region.
Fig. 20 is a plan view illustrating a modification example of the pixel according to the seventh pixel structure.
Fig. 21 is a view illustrating a manufacturing method of a pixel separation layer according to the seventh pixel structure.
Fig. 22 is a view illustrating a manufacturing method of the pixel separation layer according to the seventh pixel structure.
Fig. 23 is a view illustrating a first modification example of the pixel according to the seventh pixel structure.
Fig. 24 is a cross-sectional view illustrating second and third modification examples of the pixel according to the seventh pixel structure.
Fig. 25 is a view illustrating effects of the pixel according to the seventh pixel structure.
Fig. 26 is a view illustrating an eighth pixel structure of the pixel using the SPAD.
Fig. 27 is a view illustrating a ninth pixel structure of the pixel using the SPAD.
Fig. 28 is a view illustrating a tenth pixel structure of the pixel using the SPAD.
Fig. 29 is a cross-sectional view illustrating a pixel structure example of a stacked structure.
Fig. 30 is a diagram illustrating a circuit configuration example of a pixel that performs active quenching.
Fig. 31 is a block diagram illustrating a configuration example of a light receiving element to which the present technology is applied.
Fig. 32 is a block diagram illustrating a configuration example of a distance measuring system to which the present technology is applied.
Fig. 33 is a block diagram illustrating a configuration example of a smartphone as an electronic device to which the present technology is applied.
Fig. 34 is a block diagram illustrating an example of a schematic configuration of a vehicle control system.
Fig. 35 is an explanatory diagram illustrating an example of installation positions of an outside-vehicle information detection units and imaging sections.

### MODE FOR CARRYING OUT THE INVENTION

Hereinafter, modes for carrying out the present technology (hereinafter referred to as an embodiment) will be described with reference to the accompanying drawings. Note that in the description and the drawings, components having substantially the same function and configuration are denoted by the same reference numerals, and redundant descriptions are omitted. The description will be made in the following order.
1. Pixel circuit using SPAD
2. First pixel structure of pixel
3. Modification example of first pixel structure of pixel
4. Second pixel structure of pixel
5. Third pixel structure of pixel
6. Fourth pixel structure of pixel
7. Fifth pixel structure of pixel
8. Sixth pixel structure of pixel
9. Seventh pixel structure of pixel
10. Manufacturing method of seventh pixel structure
11. Modification example of seventh pixel structure of pixel
12. Eighth pixel structure of pixel
13. Ninth pixel structure of pixel
14. Tenth pixel structure of pixel
15. Configuration example of stacked structure
16. Pixel circuit that performs active quenching
17. Configuration example of light receiving element
18. Configuration example of distance measuring system
19. Application example to electronic device
20. Application example to mobile body

Note that in the drawings referred to in the following description, the same or similar parts are denoted by the same or similar reference numerals. However, the drawings are schematic, and the relationship between the thickness and the plane dimension, the ratio of the thickness of each layer, and the like are different from the actual ones. Furthermore, the drawings may include portions having different dimensional relationships and ratios.

Furthermore, definitions of directions such as up and down in the following description are merely definitions for convenience of description, and do not limit the technical idea of the present disclosure. For example, when an object is observed by rotating the object by 90°, the upper and lower sides are read by converting into left and right, and when an object is observed by rotating the object by 180°, the upper and lower sides are read by inverting.

### <1. Pixel circuit using SPAD>

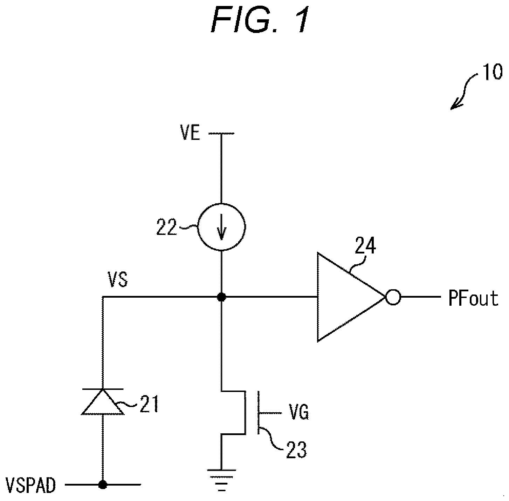

Fig. 1 illustrates a pixel circuit using a single photon avalanche diode (SPAD) applicable to a light receiving element of a distance measuring sensor that measures a distance by a time-of-flight (ToF) method.

The pixel 10 in Fig. 1 includes a SPAD 21, a constant current source 22, a transistor 23, and an inverter 24.

A cathode of the SPAD 21 is connected to the constant current source 22, and is connected to an input terminal of the inverter 24 and a drain of the transistor 23. An anode of the SPAD 21 is connected to a power supply VSPAD.

The SPAD 21 is a photodiode (single photon avalanche photodiode) that performs avalanche amplification of generated electrons and outputs a signal of a cathode voltage VS when incident light is incident. The power supply VSPAD supplied to the anode of the SPAD 21 is, for example, a negative bias (negative potential) having the same voltage as the breakdown voltage VBD of the SPAD 21.

The constant current source 22 includes, for example, a P-type MOS transistor that operates in a saturation region, and performs passive quenching by acting as a quenching resistor. A power supply voltage VE (VE > 0) is supplied to the constant current source 22. Note that for the constant current source 22, a pull-up resistor or the like can also be used instead of the P-type MOS transistor.

In order to detect light (photons) with sufficient efficiency, a voltage (hereinafter referred to as excess bias (ExcessBias)) larger than the breakdown voltage VBD of the SPAD 21 is applied to the SPAD 21.

The drain of the transistor 23 is connected to the cathode of the SPAD 21, the input terminal of the inverter 24, and the constant current source 22, and a source of the transistor 23 is connected to the ground (GND). A gating control signal VG is supplied to a gate of the transistor 23 from a pixel drive section that drives a pixel.

In a case where the pixel 10 is an active pixel, a low (Lo) gating control signal VG is supplied from the pixel drive section to the gate of the transistor 23. On the other hand, in a case where the pixel 10 is an inactive pixel, a high (Hi) gating control signal VG is supplied from the pixel drive section to the gate of the transistor 23.

The inverter 24 outputs a Hi PFout signal when the cathode voltage VS as an input signal is Lo, and outputs a Lo PFout signal when the cathode voltage VS is Hi.

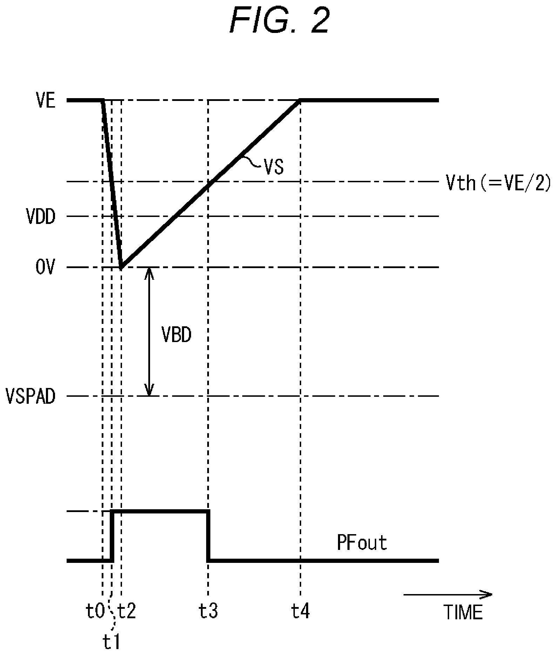

Next, an operation in a case where the pixel 10 is set as an active pixel will be described with reference to Fig. 2. Fig. 2 is a graph illustrating a change in the cathode voltage VS of the SPAD 21 in response to incidence of photons and a detection signal PFout.

First, in a case where the pixel 10 is an active pixel, the transistor 23 is set to off by the Lo gating control signal VG.

At a time before time to in Fig. 2, since the power supply voltage VE is supplied to the cathode of the SPAD 21 and the power supply VSPAD is supplied to the anode, a reverse voltage larger than the breakdown voltage VBD is applied to the SPAD 211, thereby setting the SPAD 21 to the Geiger mode. In this state, the cathode voltage VS of the SPAD 21 is the same as the power supply voltage VE.

When photons are incident on the SPAD 21 set in Geiger mode, avalanche multiplication occurs, and a current flows through the SPAD 21.

When avalanche multiplication occurs at time t0 and a current flows through the SPAD 21, after time t0, by the current flowing through the SPAD 21, a current also flows through the P-type MOS transistor as the constant current source 22, and a voltage drop occurs due to a resistance component of the MOS transistor.

When the cathode voltage VS of the SPAD 21 becomes lower than 0 V at time t2, the voltage becomes lower than the breakdown voltage VBD, so that the avalanche amplification stops. Here, a quenching operation is such that the current generated by the avalanche amplification flows through the constant current source 22 to generate a voltage drop, and the cathode voltage VS becomes lower than the breakdown voltage VBD along with the generated voltage drop, thereby stopping the avalanche amplification.

When the avalanche amplification is stopped, the current flowing through the constant current source 22 (P-type MOS transistor) gradually decreases, and at time t4, the cathode voltage VS returns to the original power supply voltage VE again, making it capable of detecting a next new photon (recharging operation).

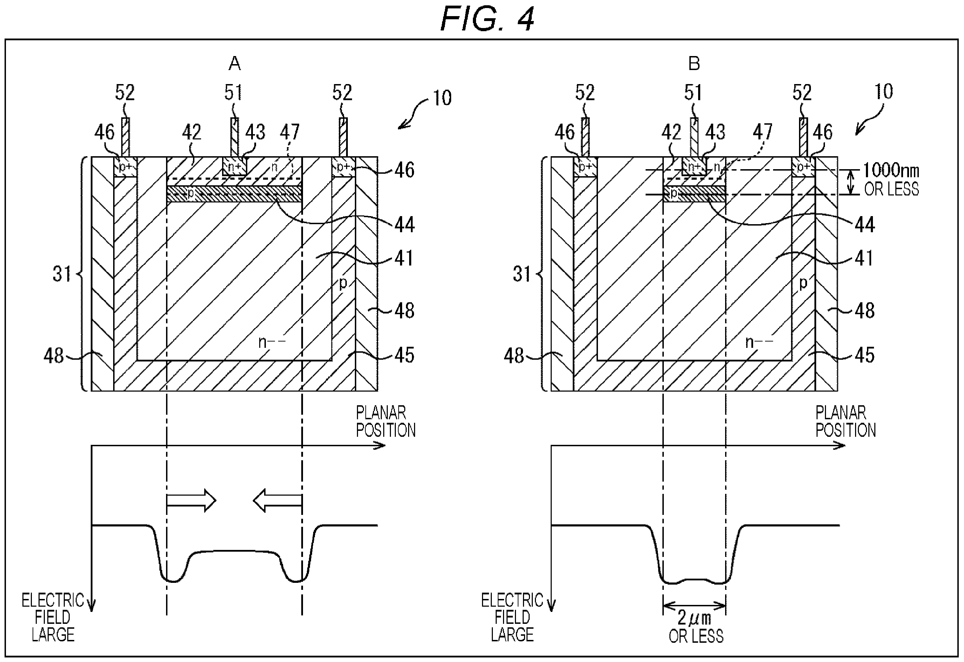

The inverter 24 outputs the Lo (low) PFout signal when the cathode voltage VS, which is an input voltage, is equal to or higher than a predetermined threshold voltage Vth (= VE/2), and outputs the Hi PFout signal when the cathode voltage VS is lower than the predetermined threshold voltage Vth. In the example of Fig. 4, the Hi (high) PFout signal is output in a period from time t1 to time t3.

Note that, in a case where the pixel 10 is an inactive pixel, the Hi gating control signal VG is supplied from the pixel drive section to the gate of the transistor 23, and the transistor 23 is turned on. Thus, the cathode voltage VS of the SPAD 21 becomes 0 V (GND), and an anode-cathode voltage of the SPAD 21 becomes equal to or lower than the breakdown voltage VBD, and thus no reaction occurs even if photons enter the SPAD 21.

### <2. First pixel structure of pixel>

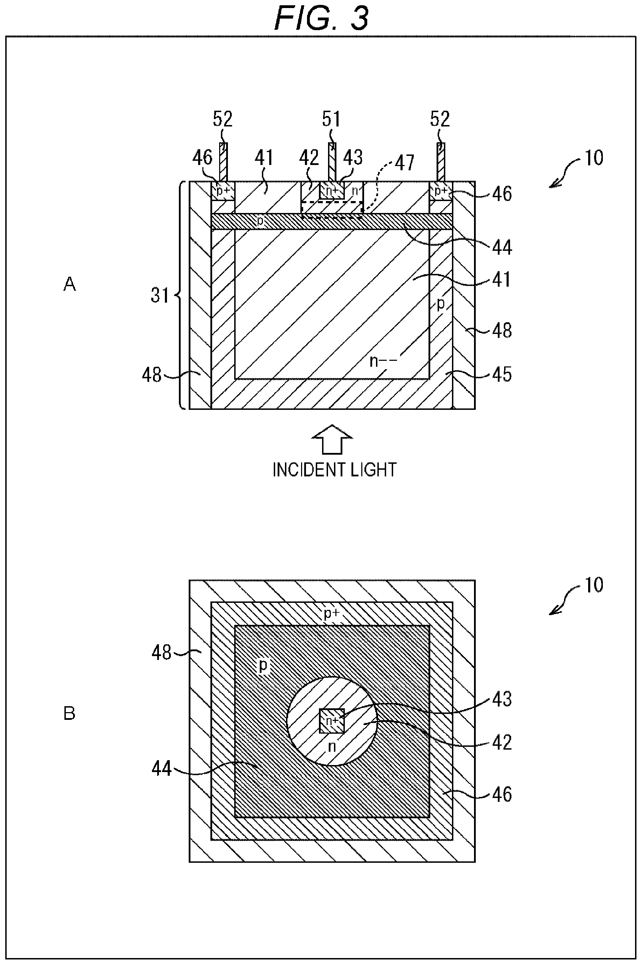

Fig. 3 is a view illustrating a first pixel structure of the pixel 10 using the SPAD 21 described above.

Fig. 3 illustrates a pixel structure of a portion corresponding to one pixel among a plurality of pixels formed on a semiconductor substrate 31 including silicon or the like, and A of Fig. 3 is a cross-sectional view of the pixel 10.

In the cross-sectional view of the pixel 10 illustrated in A of Fig. 3, only the structure of the semiconductor substrate 31 is illustrated, and a lower side of A of Fig. 3 is a back surface side of the semiconductor substrate 31, which is an incident surface side on which an on-chip lens or the like are formed, and reflected light that is reflected from the object is incident.

On the other hand, an upper side of A of Fig. 3 is a front surface side of the semiconductor substrate 31, and although not illustrated, a wiring layer including a circuit for driving the pixel and the like is formed.

B of Fig. 3 is a plan view of the pixel 10 of A of Fig. 3 as viewed from the front surface side of the semiconductor substrate 31.

As illustrated in A of Fig. 3, the pixel 10 includes an n-well 41, an n-type semiconductor region 42, a high-concentration n-type semiconductor region 43, a p-type semiconductor region 44, a hole accumulation region 45, and a high-concentration p-type semiconductor region 46. Then, an avalanche multiplication region 47 is formed by a depletion layer formed in a region where the n-type semiconductor region 42 and the p-type semiconductor region 44 are bonded.

The n-well 41 is formed by being controlled to n-type (n-) in which impurity concentration of the semiconductor substrate 31 is thin, and forms an electric field that transfers electrons generated by photoelectric conversion in the pixel 10 to the avalanche multiplication region 47. Note that instead of the n-well 41, a p-well in which the impurity concentration of the semiconductor substrate 31 is controlled to p-type may be formed.

As illustrated in B of Fig. 3, the n-type semiconductor region 42 is a thick n-type (first conductivity type) semiconductor region (first semiconductor region) formed at a predetermined depth from the front surface side of the semiconductor substrate 31 in a central portion of the pixel region. Then, in the n-type semiconductor region 42, in particular, the vicinity of a surface of a central portion is controlled to have a high concentration (n+) of impurities to form the high-concentration n-type semiconductor region 43. The high-concentration n-type semiconductor region 43 is a contact portion (first contact portion) connected to a contact electrode 51 as a cathode for supplying a negative voltage for forming the avalanche multiplication region 47. The power supply voltage VE is applied from the contact electrode 51 to the high-concentration n-type semiconductor region 43.

The p-type semiconductor region 44 is a thick p-type (second conductivity type) semiconductor region (second semiconductor region) formed from a depth position in contact with a bottom surface of the n-type semiconductor region 42 in the semiconductor substrate 31 over the entire surface of the pixel region with a predetermined thickness (depth).

Here, the impurity concentration of the n-well 41 is set to a low concentration of, for example, 1E + 14/cm³ or less, and the impurity concentration of each of the n-type semiconductor region 42 and the p-type semiconductor region 44 forming the avalanche multiplication region 47 is desirably controlled to have a high concentration of 1E + 16/cm³ or more.

The hole accumulation region 45 is a p-type semiconductor region (p) formed so as to surround a side surface and a bottom surface of the n-well 41, and accumulates holes generated by photoelectric conversion. Furthermore, the hole accumulation region 45 traps electrons generated at the interface with the pixel separation portion 48 and also has an effect of suppressing a dark count rate (DCR). A region in the vicinity of the substrate front surface side of the hole accumulation region 45 is particularly controlled to have a high impurity concentration (p+) to form the high-concentration p-type semiconductor region 46. The high-concentration p-type semiconductor region 46 is a contact portion (second contact portion) connected to the contact electrode 52 as an anode of the SPAD 21. The power supply VSPAD is applied from the contact electrode 52 to the high-concentration p-type semiconductor region 46. The hole accumulation region 45 can be formed by ion implantation, and may be formed by solid-phase diffusion.

A pixel separation portion 48 that isolates pixels from each other is formed at a pixel boundary portion of the pixel 10, which is a boundary with an adjacent pixel. For example, the pixel separation portion 48 may include only an insulating layer such as a silicon oxide film, or may have a double structure such that an outer side (n-well 41 side) of a metal layer such as tungsten is covered with an insulating layer such as a silicon oxide film.

As described above, in the pixel 10 according to the first pixel structure, regarding planar regions of the n-type semiconductor region 42 and the p-type semiconductor region 44 in which the avalanche multiplication region 47 is formed, the planar region of the p-type semiconductor region 44 is formed larger than the planar region of the n-type semiconductor region 42. Furthermore, regarding depth positions of the n-type semiconductor region 42 and the p-type semiconductor region 44 from the substrate front surface, the p-type semiconductor region 44 is formed at a deeper position than the depth position of the n-type semiconductor region 42. In other words, the p-type semiconductor region 44 is formed at a position closer to a light receiving surface than the n-type semiconductor region 42.

Note that, in the plan view illustrated in B of Fig. 3 in which the pixel 10 is viewed from the front surface side of the semiconductor substrate 31, the region between the n-type semiconductor region 42 and the high-concentration p-type semiconductor region 46 is exactly the n-well 41, but the p-type semiconductor region 44 lower than the n-well 41 illustrated in order to illustrate a difference in region size between the n-type semiconductor region 42 and the p-type semiconductor region 44.

The first pixel structure in Fig. 3 is an example of a structure in which electrons are read out as signal charges (carriers), but a structure in which holes are read out may be used. In this case, the n-type semiconductor region 42 having a small planar size is changed to a p-type semiconductor region, and the high-concentration n-type semiconductor region 43 is changed to a high-concentration p-type semiconductor region. The p-type semiconductor region 44 having a large planar size is changed to an n-type semiconductor region, and the high-concentration p-type semiconductor region 46 is changed to a high-concentration n-type semiconductor region. The power supply VSPAD is applied from the contact electrode 51 to the contact portion changed from the high-concentration n-type semiconductor region 43 to the high-concentration p-type semiconductor region, and the power supply voltage VE is applied from the contact electrode 52 to the contact portion changed from the high-concentration p-type semiconductor region 46 to the high-concentration n-type semiconductor region.

### <Operations and effects of first pixel structure>

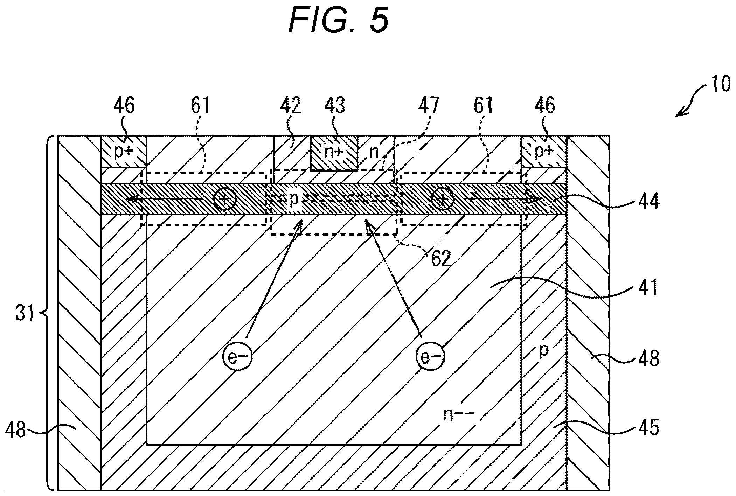

The effect of the structure in which the planar region of the p-type semiconductor region 44 is formed larger than the planar region of the n-type semiconductor region 42 in which the avalanche multiplication region 47 is formed will be described with reference to Figs. 4 and 5.

In the description of Fig. 4, the same reference numerals as those in Fig. 3 are given to facilitate understanding.

In general, as illustrated in A of Fig. 4, a structure is conceivable in which the n-type semiconductor region 42 and the p-type semiconductor region 44 in which the avalanche multiplication region 47 is formed are formed in the same plane region so that connection regions overlap.

In this case, as illustrated in the electric field graph on a lower side of A of Fig. 4, an end of the avalanche multiplication region 47 becomes a strong electric field, and edge breakdown occurs.

Therefore, as illustrated in B of Fig. 4, by reducing the planar sizes of the n-type semiconductor region 42 and the p-type semiconductor region 44 in which the avalanche multiplication region 47 is formed, it is possible to form the avalanche multiplication region 47 using, so to speak, only the strong electric field portion only at the end portion in A of Fig. 4 and having a strong and uniform electric field. In order to form such an avalanche multiplication region 47 having a uniform electric field, for example, the diameter of the n-type semiconductor region 42 is preferably two um or less, and a relative distance in a depth direction between the n-type semiconductor region 42 and the p-type semiconductor region 44 is preferably 1000 nm or less.

Therefore, by reducing the planar size of the avalanche multiplication region 47, the electric field can be made uniform and the edge breakdown can be prevented, but in the first pixel structure of Fig. 3, the p-type semiconductor region 44 extends to the hole accumulation region 45 in a pixel peripheral portion.

The effect of the p-type semiconductor region 44 extending to the hole accumulation region 45 in the pixel peripheral portion will be described with reference to Fig. 5.

Holes generated by the avalanche amplification move to the hole accumulation region 45 via the p-type semiconductor region 44. An outer peripheral region 61, which is a region of the p-type semiconductor region 44 outside the n-type semiconductor region 42 in a planar direction, forms a hole current path and has an effect of improving internal resistance (reducing hole resistance).

Furthermore, since the p-type semiconductor region 44 is formed in the outer peripheral region 61 of the avalanche multiplication region 47 in the planar direction, electrons generated in the n-well 41 by incidence of incident light move to the avalanche multiplication region 47 inside the outer peripheral region 61. That is, the p-type semiconductor region 44 of the outer peripheral region 61 has a shielding effect, and the electrons of the n-well 41 move to the avalanche multiplication region 47 in a barrierless manner. A barrierless structure from the n-well 41 to the avalanche multiplication region 47 achieves high charge collection efficiency.

Therefore, with the first pixel structure of the pixel 10 illustrated in Fig. 3, high PDE can be achieved while edge break is prevented. The achievement of high PDE also allows for low overbias.

### <3. Modification example of first pixel structure of pixel>

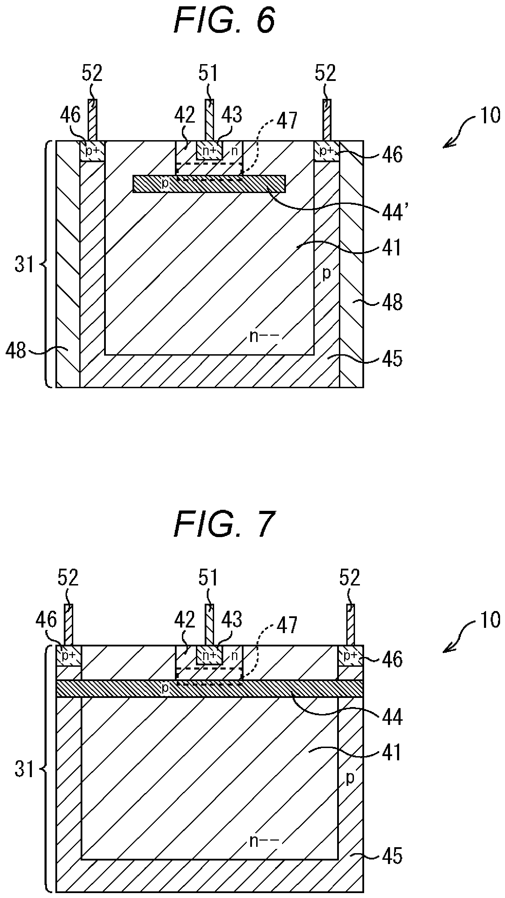

Fig. 6 is a cross-sectional view illustrating a first modification example of the pixel 10 according to the first pixel structure.

Note that, in Fig. 6 and subsequent drawings, parts corresponding to those of the first pixel structure illustrated in Fig. 3 are denoted by the same reference numerals, and description of the parts will be omitted as appropriate.

In the first modification example of Fig. 6, the p-type semiconductor region 44 forming the avalanche multiplication region 47 in the first pixel structure illustrated in Fig. 3 is changed to a p-type semiconductor region 44'.

In the first pixel structure illustrated in Fig. 3, the planar region of the p-type semiconductor region 44 extends until reaching the hole accumulation region 45 in the pixel peripheral portion, but the p-type semiconductor region 44' of the first modification example of Fig. 6 does not extend to reach the hole accumulation region 45, and an n-well 41 (fourth semiconductor region) is formed between the p-type semiconductor region 44' and the hole accumulation region 45. However, the planar region of the p-type semiconductor region 44' is formed to be larger than the planar region of the n-type semiconductor region 42.

As described above, even in a case where the p-type semiconductor region 44' is not formed large enough to be in contact with the hole accumulation region 45, since the p-type semiconductor region 44' is formed larger than at least the n-type semiconductor region 42, the region (the outer peripheral region 61 in Fig. 5) of the p-type semiconductor region 44 outside the n-type semiconductor region 42 in the planar direction forms the hole current path, and thus an effect of improving the internal resistance (reducing hole resistance) is obtained.

Fig. 7 is a cross-sectional view illustrating a second modification example of the pixel 10 according to the first pixel structure.

In the first pixel structure illustrated in Fig. 3, the pixel separation portion 48 that separates pixels from each other is formed at the pixel boundary portion of the pixel 10, and the hole accumulation region 45 is formed on the side surface (near the pixel boundary portion) on the pixel center side of the pixel separation portion 48.

On the other hand, in the second modification example of Fig. 7, the pixel separation portion 48 of Fig. 3 is omitted. Thus, as compared with the first pixel structure in Fig. 3, the hole accumulation region 45 is provided in the outer peripheral portion so as to be in contact with the boundary portion with the adjacent pixel, and the region of the n-well 41 is formed to be wider than the first pixel structure in Fig. 3.

In this manner, the pixel separation portion 48 can be omitted.

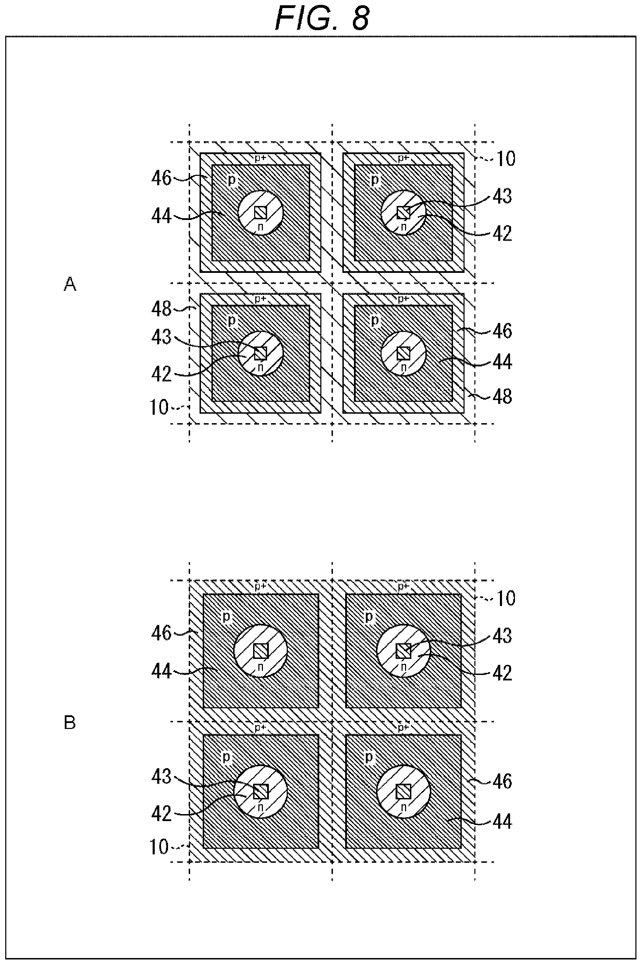

A of Fig. 8 illustrates a plan view of four pixel regions in which the pixels 10 according to the first pixel structure illustrated in Fig. 3 are arrayed in 2 × 2, as viewed from the front surface side of the semiconductor substrate 31.

B of Fig. 8 illustrates a plan view of four pixel regions in which the pixels 10 according to the second modification example illustrated in Fig. 7 are arrayed in 2 × 2, as viewed from the front surface side of the semiconductor substrate 31.

In A and B of Fig. 8, dashed lines indicate boundaries of the pixels 10.

In a case where the pixel separation portion 48 is formed at the boundary portions of the pixels 10, as illustrated in A of Fig. 8, the pixel separation portion 48 is arranged around the pixels 10, and in an array of a plurality of pixels, the pixel separation portion 48 is arranged in a lattice pattern.

On the other hand, in a case where the pixel separation portion 48 is not formed at the boundary portions of the pixels 10, as illustrated in B of Fig. 8, the hole accumulation regions 45 are arranged around the pixels 10, and in an array of a plurality of pixels, the hole accumulation regions 45 are arranged in a lattice pattern.

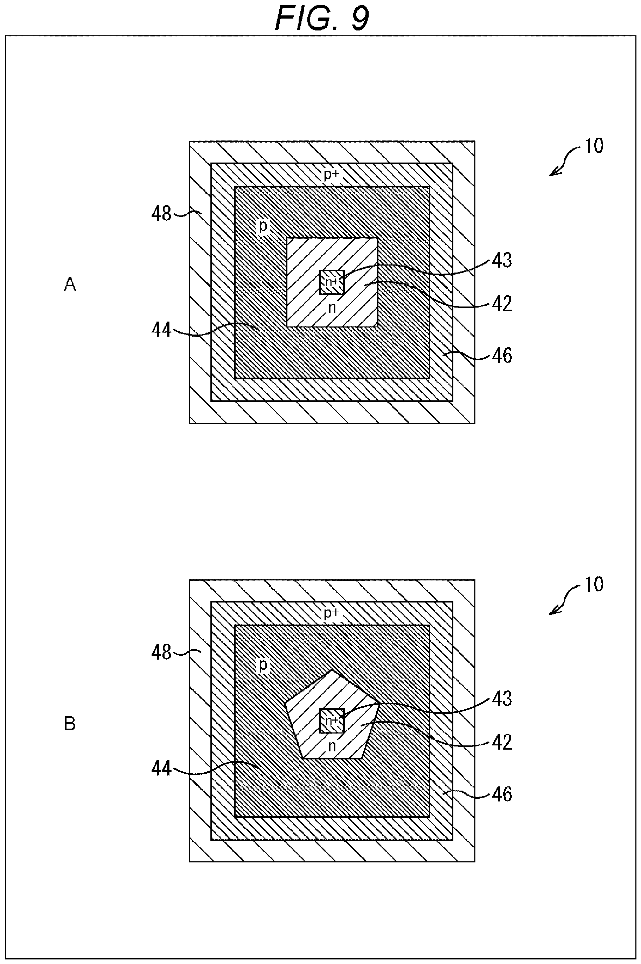

Fig. 9 is a third modification example of the pixel 10 according to the first pixel structure, and illustrates a modification example of the planar shape of the n-type semiconductor region 42. The structure other than the n-type semiconductor region 42 is similar to the first pixel structure illustrated in Fig. 3.

In the first pixel structure illustrated in Fig. 3, the planar shape of the n-type semiconductor region 42 is a circular shape, but the planar shape of the n-type semiconductor region 42 is not limited to a circular shape, and may be a quadrangle, a pentagon, or other polygonal shapes.

A of Fig. 9 illustrates an example in which the planar shape of the n-type semiconductor region 42 is a quadrangular shape.

B of Fig. 9 illustrates an example in which the planar shape of the n-type semiconductor region 42 is a pentagonal shape.

### <4. Second pixel structure of pixel>

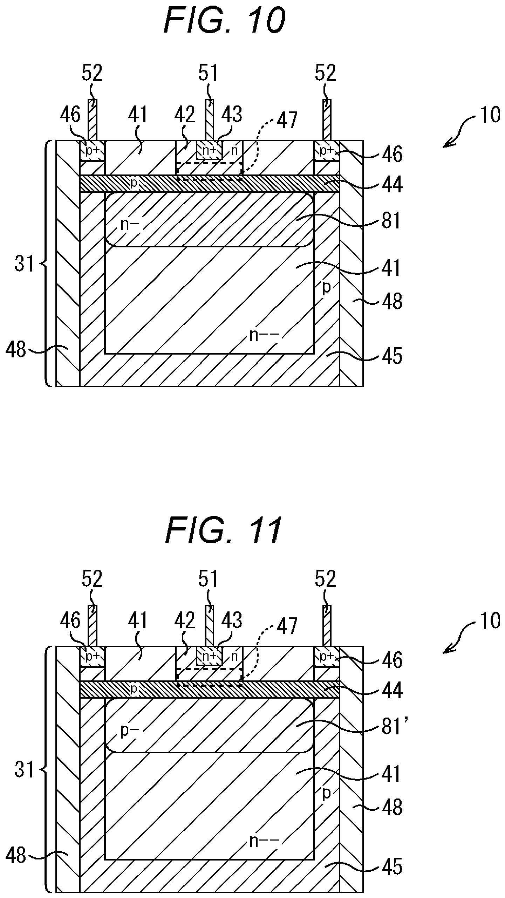

Fig. 10 is a cross-sectional view illustrating a second pixel structure of the pixel 10 using the SPAD 21. Note that a plan view of the pixel 10 according to the second pixel structure as viewed from the front surface side of the semiconductor substrate 31 is similar to B of Fig. 3 in the first pixel structure, and thus is omitted.

When the pixel 10 according to the second pixel structure of Fig. 10 is compared with the pixel 10 according to the first pixel structure illustrated in Fig. 3, an n-type semiconductor region 81 (fourth semiconductor region) of n-type (n-) having an impurity concentration higher than that of the n-well 41 is formed in a region deeper (closer to the light receiving surface) than the n-type semiconductor region 42 and the p-type semiconductor region 44 forming the avalanche multiplication region 47.

In other words, in the pixel 10 according to the first pixel structure illustrated in Fig. 3, the n-well 41 surrounded by the p-type semiconductor region 44 and the hole accumulation region 45 is replaced with the n-well 41 having a low impurity concentration and the n-type semiconductor region 81 having an impurity concentration higher than that of the n-well 41, and the n-type semiconductor region 81 is arranged between the n-well 41 and the p-type semiconductor region 44.

Thus, a potential gradient is formed such that carriers (electrons) generated in the n-well 41 easily drift toward the avalanche multiplication region 47.

Note that, depending on the design of the potential gradient, not the n-type semiconductor region 81 having the same conductivity type as the n-well 41 but a p-type semiconductor region 81' (fourth semiconductor region) having a conductivity type different from that of the n-well 41 and a lower impurity concentration than the p-type semiconductor region 44 may be used as illustrated in Fig. 11.

The n-type semiconductor region 81 and the p-type semiconductor region 81' can be formed by ion implantation in which n-type or p-type ions are implanted.

### <5. Third pixel structure of pixel>

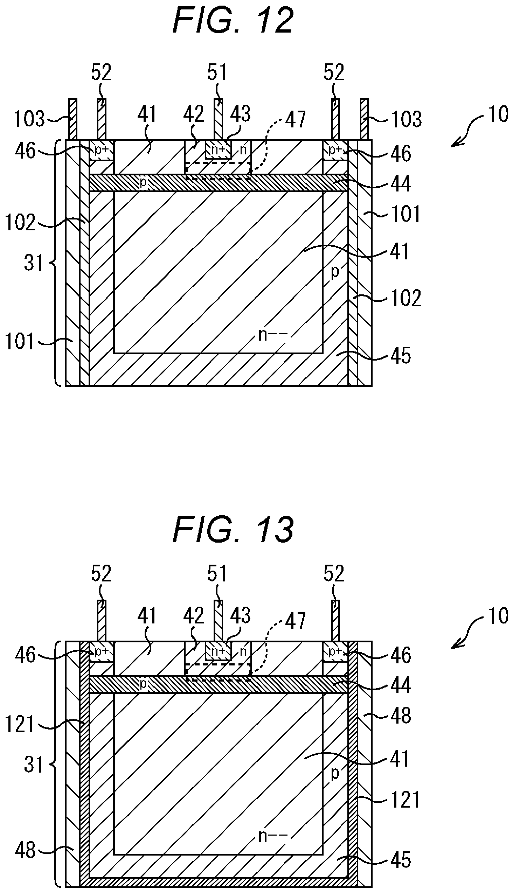

Fig. 12 is a cross-sectional view illustrating a third pixel structure of the pixel 10 using the SPAD 21.

When the pixel 10 according to the third pixel structure in Fig. 12 is compared with the pixel 10 according to the first pixel structure illustrated in Fig. 3, the pixel separation portion 48 formed at the pixel boundary portion is replaced with an inter-pixel trench portion 101 penetrating the semiconductor substrate 31 from the front surface side to the back surface side and insulating layers 102. The inter-pixel trench portion 101 is formed by, for example, a metal material such as tungsten (W), aluminum (Al), titanium (Ti), or titanium nitride (TiN), or a conductive material such as polysilicon, and a negative voltage larger than that of the anode electrode (contact electrode 52) of the SPAD 21 is applied from the front surface side of the semiconductor substrate 31 on which the wiring layer is formed. The insulating layers 102 are formed by, for example, SiO2.

The planar arrangement of the inter-pixel trench portion 101 and the insulating layers 102 has a lattice shape similar to that of the pixel separation portion 48 illustrated in A of Fig. 8.

By forming such inter-pixel trench portion 101 and insulating layers 102, the influence of adjacent pixels can be further reduced, and crosstalk can be further reduced. Furthermore, formation of a lateral electric field makes it easy to collect carriers in the high electric field region, and PDE can be improved.

### <6. Fourth pixel structure of pixel>

Fig. 13 is a cross-sectional view illustrating a fourth pixel structure of the pixel 10 using the SPAD 21.

When the pixel 10 according to the fourth pixel structure in Fig. 13 is compared with the pixel 10 according to the first pixel structure illustrated in Fig. 3, a fixed charge film 121 is formed between the pixel separation portion 48 and the hole accumulation region 45 formed at the pixel boundary portion. The fixed charge film 121 is also formed outside the hole accumulation region 45 on the back surface side of the semiconductor substrate 31 in addition to side surfaces between the pixel separation portion 48 and the hole accumulation region 45.

The fixed charge film 121 is a negative fixed charge film. A hole accumulation region is formed inside the fixed charge film 121 by induction of holes by the fixed charge film 121. A dark current can be suppressed by combining the hole accumulation region formed by the fixed charge film 121 and the hole accumulation region 45 formed inside the hole accumulation region, and the DCR can be suppressed. Furthermore, it is possible to easily collect carriers in a high electric field region by reducing crosstalk and forming the lateral electric field, and the PDE can be improved.

### <7. Fifth pixel structure of pixel>

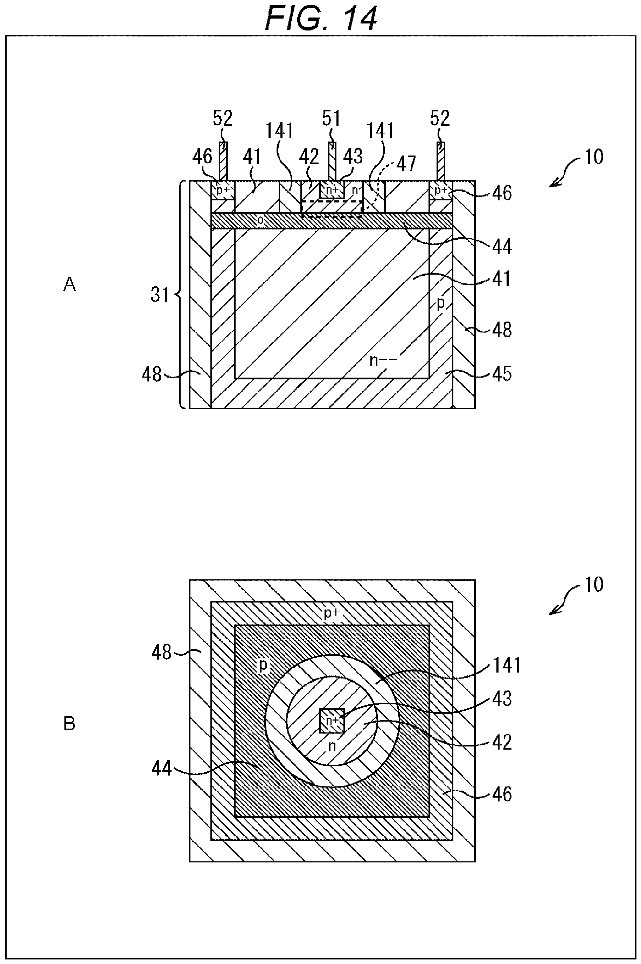

A of Fig. 14 is a cross-sectional view illustrating a fifth pixel structure of the pixel 10 using the SPAD 21, and B of Fig. 14 is a plan view of the pixel 10 in A of Fig. 14 as viewed from the front surface side of the semiconductor substrate 31.

When the pixel 10 according to the fifth pixel structure in Fig. 14 is compared with the pixel 10 according to the first pixel structure illustrated in Fig. 3, an insulating layer 141 formed by shallow trench isolation (STI) is newly added.

As illustrated in B of Fig. 14, the insulating layer 141 is formed on the outer peripheries of the n-type semiconductor region 42 and the high-concentration n-type semiconductor region 43 connected to the contact electrode 51 as the cathode of the SPAD 21 in the planar direction, and electrically separates the anode and the cathode of the SPAD 21 from each other.

Note that, because of its purpose to electrically separate the anode and the cathode of the SPAD 21, the insulating layer 141 is not always necessary to be arranged in the periphery adjacent to the n-type semiconductor region 42, and is only required to be arranged between the n-type semiconductor region 42 and the high-concentration n-type semiconductor region 43 electrically connected to the contact electrode 51 and the high-concentration p-type semiconductor region 46 electrically connected to the contact electrode 52. For example, the insulating layer 141 may be formed on the inner peripheral side of the high-concentration p-type semiconductor region 46 near the substrate front surface.

In B of Fig. 14, the region between the n-type semiconductor region 42 and the high-concentration p-type semiconductor region 46 is exactly the n-well 41, but the point that the p-type semiconductor region 44 lower than the n-well 41 is illustrated is similar to B of Fig. 3.

### <8. Sixth pixel structure of pixel>

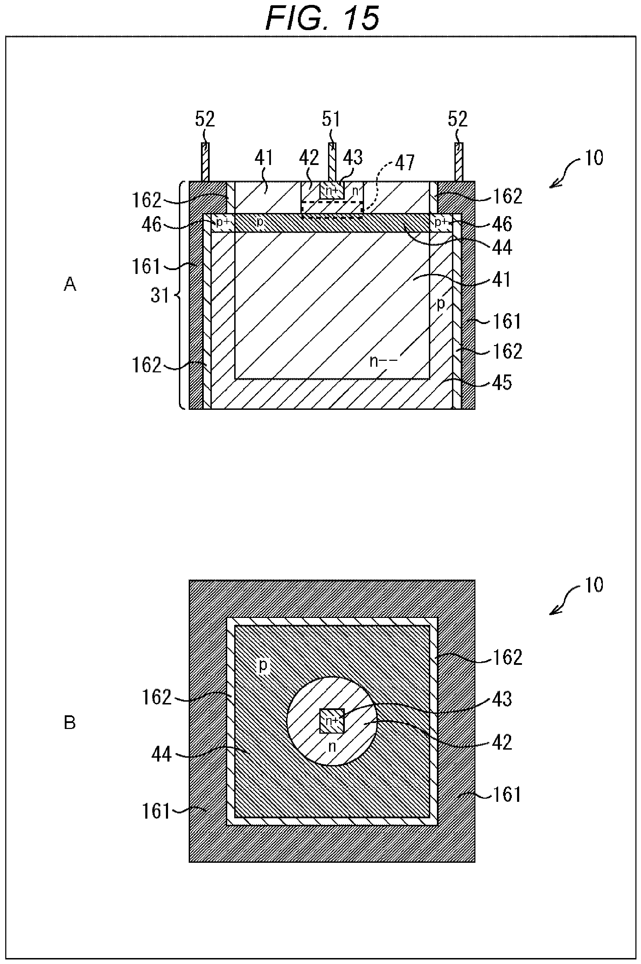

A of Fig. 15 is a cross-sectional view illustrating a sixth pixel structure of the pixel 10 using the SPAD 21, and B of Fig. 15 is a plan view of the pixel 10 in A of Fig. 15 as viewed from the front surface side of the semiconductor substrate 31.

The pixel 10 according to the fifth pixel structure illustrated in Fig. 14 has a configuration in which the anode and the cathode of the SPAD 21 are separated in the planar direction using the insulating layer 141, but the pixel 10 according to the sixth pixel structure illustrated in Fig. 15 has a configuration in which the anode and the cathode of the SPAD 21 are separated by arranging the anode and the cathode of the SPAD 21 at different depth positions of the semiconductor substrate 31.

Specifically, when the pixel 10 according to the sixth pixel structure in Fig. 15 is compared with the pixel 10 according to the first pixel structure illustrated in Fig. 3, the pixel separation portion 48 at the pixel boundary portion of the pixel 10 is replaced with a conductive member 161 penetrating the substrate surface on the opposite side from the back surface side or the front surface side of the semiconductor substrate 31 and an insulating film 162 formed on both outer sides (inside the pixel) thereof. The conductive member 161 is formed by, for example, a metal material such as polysilicon or tungsten (W), and the insulating film 162 is formed by, for example, SiO2.

Furthermore, the high-concentration p-type semiconductor region 46, which is the contact portion of the anode of the SPAD 21, is embedded and arranged in the semiconductor substrate 31. In the example of A of Fig. 15, the position in the depth direction of the high-concentration p-type semiconductor region 46 is formed at the same position as the p-type semiconductor region 44, but the positions in the depth direction of the high-concentration p-type semiconductor region 46 and the p-type semiconductor region 44 are not necessarily the same. The high-concentration p-type semiconductor region 46 on the anode side and the n-type semiconductor region 42 and the high-concentration n-type semiconductor region 43 on the cathode side are only required to be arranged at different depth positions.

The conductive member 161 is connected to the contact electrode 52 on an upper surface of the front surface of the semiconductor substrate 31, and is connected to the high-concentration p-type semiconductor region 46 in the semiconductor substrate 31, and the high-concentration p-type semiconductor region 46 is electrically connected to the contact electrode 52 via the conductive member 161. The outer peripheral portion of the conductive member 161 other than the connection region connected to the high-concentration p-type semiconductor region 46 is covered with the insulating film 162, and is electrically separated from the n-well 41 and the hole accumulation region 45.

As described above, the configuration in which the anode and the cathode of the SPAD 21 are arranged at the different positions in the depth direction of the semiconductor substrate 31 and separated is effective in a case where the pixel size is reduced. That is, when the anode and the cathode of the SPAD 21 are arranged on the same plane, there is a limit in a case where the pixel size is miniaturized. Furthermore, since the anode and the cathode of the SPAD 21 are close to each other, electrical separation is difficult. By arranging the pixels so as to be shifted in the depth direction, the pixel size can be further reduced as compared with a case where the pixels are arranged on the same plane.

### <9. Seventh pixel structure of pixel>

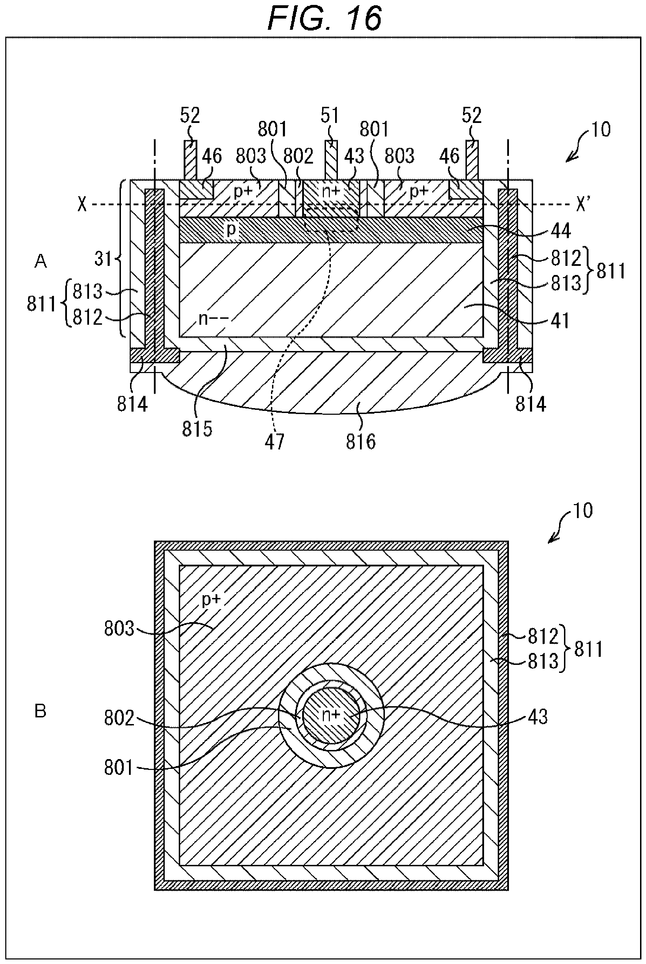

A of Fig. 16 is a cross-sectional view illustrating a seventh pixel structure of the pixel 10 using the SPAD 21, and B of Fig. 16 is a plan view of the pixel 10 taken along line X-X' in A of Fig. 16.

In Figs. 16 to 28 to be referred to below, the same reference numerals are given to portions common to the above-described first pixel structure, and the description of the portions will be appropriately omitted.

In the pixel 10 according to the seventh pixel structure, the point that the avalanche multiplication region 47 is formed by the depletion layer formed in the junction region between the high-concentration n-type semiconductor region 43 connected to the contact electrode 51 as the cathode and the p-type semiconductor region 44 formed therebelow is similar to the first to sixth pixel structures described above.

In the cross-sectional view of A of Fig. 16, an on-chip lens 816 omitted in the above-described first to sixth pixel structures is illustrated. The on-chip lens 816 is formed on the back surface side of the semiconductor substrate 31, which is a lower side of A of Fig. 16. The contact electrode 51 as a cathode, the contact electrode 52 as an anode, and the like are formed on the front surface of the semiconductor substrate 31.

Between the high-concentration n-type semiconductor region 43 connected to the contact electrode 51 as a cathode and the high-concentration p-type semiconductor region 46 connected to the contact electrode 52 as an anode in the substrate planar direction (lateral direction in Fig. 16), a separation layer 801 physically and electrically separating them is formed. This separation layer 801 is formed by, for example, a silicon oxide film (SiO2), and has a function similar to that of the insulating layer 141 of the pixel 10 according to the fifth pixel structure illustrated in Fig. 14. That is, by electrically separating the anode and the cathode of the SPAD 21 by the separation layer 801, edge breakdown in the planar direction between the anode and the cathode can be suppressed. In particular, even in a case where the pixel size of the pixel 10 is reduced and the distance between the anode and the cathode is shortened, the edge breakdown can be reliably suppressed.

A low-concentration n-type semiconductor region 802 (sixth semiconductor region) having the same conductivity type (n-type) as the high-concentration n-type semiconductor region 43 and a lower impurity concentration than the high-concentration n-type semiconductor region 43 is formed between the separation layer 801 and the high-concentration n-type semiconductor region 43. Moreover, between the separation layer 801 and the high-concentration p-type semiconductor region 46, a high-concentration p-type semiconductor region 803 (fifth semiconductor region) having a conductivity type (p-type) opposite to that of the high-concentration n-type semiconductor region 43 and an impurity concentration higher than that of the p-type semiconductor region 44 is formed. Note that, in the drawings (for example, Fig. 14 and the like) illustrating the first to sixth pixel structures described above, the impurity concentration of the high-concentration p-type semiconductor region 46 is represented by "p+", and in Fig. 16, it is also represented by "p+" for the high-concentration p-type semiconductor region 803. However, the high-concentration p-type semiconductor region 46 has an impurity concentration higher than that of the high-concentration p-type semiconductor region 803. The impurity concentration of the high-concentration p-type semiconductor region 46 can be expressed as "p++" in comparison with the high-concentration p-type semiconductor region 803.

A one-dot chain line in A of Fig. 16 indicates the boundary of the pixel 10 in the planar direction of the semiconductor substrate 31, and a pixel separation portion 811 is formed at the pixel boundary portion of the pixel 10. The pixel separation portion 811 includes a metal DTI 812 using tungsten or the like, and a silicon oxide film (insulating layer) 813 formed inside the metal DTI (on the n-well 41 side). The pixel separation portion 811 is another form of the pixel separation portion 48 such as the pixel 10 according to the first pixel structure illustrated in Fig. 3. Furthermore, the metal DTI 812 and the silicon oxide film 813 can also be said to be other forms of the inter-pixel trench portion 101 and the insulating layer 102 of the third pixel structure illustrated in Fig. 12. A negative voltage may be applied to the metal DTI 812 as in the third pixel structure illustrated in Fig. 12. At a pixel boundary portion on the light incident surface side of the semiconductor substrate 31, an inter-pixel light-shielding film 814 is formed using the same material as the metal DTI 812. A silicon oxide film 815 formed simultaneously with the silicon oxide film 813 constituting the pixel separation portion 811 is formed on the interface on the back surface side of the semiconductor substrate 31.

As illustrated in B of Fig. 16, the planar shapes of the high-concentration n-type semiconductor region 43, the low-concentration n-type semiconductor region 802, and the separation layer 801 are circular. The low-concentration n-type semiconductor region 802 is formed so as to surround the outer periphery of the high-concentration n-type semiconductor region 43 formed in a circular shape, and the separation layer 801 is further formed so as to surround the outer periphery of the low-concentration n-type semiconductor region 802. The high-concentration p-type semiconductor region 803 is formed in a region between the separation layer 801 and the pixel separation portion 811 formed at the pixel boundary portion and including the metal DTI 812 and the silicon oxide film 813. The separation layer 801 physically and electrically separates the n-type semiconductor regions of the high-concentration n-type semiconductor region 43 and the low-concentration n-type semiconductor region 802 from the p-type semiconductor regions of the high-concentration p-type semiconductor region 803 and the high-concentration p-type semiconductor region 46 in the planar direction.

The pixel 10 according to the seventh pixel structure configured as described above is greatly different from the fifth pixel structure illustrated in Fig. 14 in that a region above the p-type semiconductor region 44 (substrate front surface side) in a cross-sectional view and outside the separation layer 801 in a plan view, in other words, a region between the separation layer 801 and the high-concentration p-type semiconductor region 46 is changed from the n-well 41 to the high-concentration p-type semiconductor region 803.

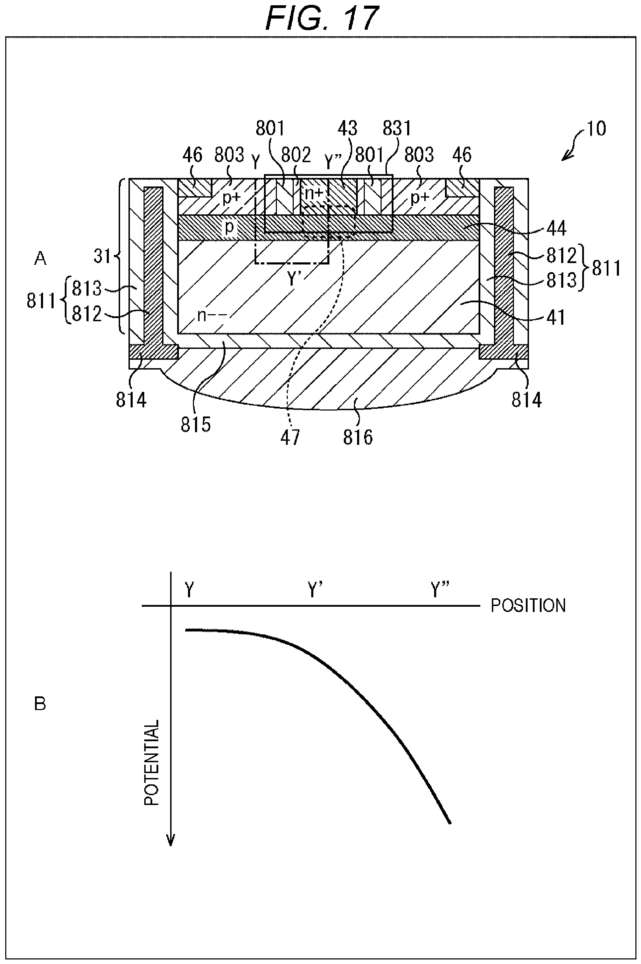

Here, a potential on a line Y-Y'-Y" indicated by a one-dot chain line in A of Fig. 17 is illustrated in B of Fig. 17. Assuming that a point Y is a start point and a point Y" is an end point, the line Y-Y'-Y" passes through the high-concentration p-type semiconductor region 803, the p-type semiconductor region 44, the n-well 41, the p-type semiconductor region 44, and the high-concentration n-type semiconductor region 43 in this order, and a potential gradient is formed in which the potential decreases from the point Y toward the point Y" via the point Y' as illustrated in B of Fig. 17. The p-type semiconductor region 44 of the avalanche multiplication region 47 is depleted.

That is, since the high-concentration p-type semiconductor region 803 is formed in the region near the substrate front surface above the p-type semiconductor region 44, the potential gradient is formed in which the potential decreases from the point Y toward the point Y" via the point Y'. Thus, the electrons photoelectrically converted in the region near the front surface of the semiconductor substrate 31 where the high-concentration p-type semiconductor region 803 is formed can be moved to the avalanche multiplication region 47 without escaping to the outside of the pixel, so that the PDE can be improved.

Note that the impurity concentration of the high-concentration p-type semiconductor region 803 is higher than the impurity concentration of the p-type semiconductor region 44, but is lower than that of the high-concentration p-type semiconductor region 46 connected to the anode (contact electrode 52). In other words, the energy level of the high-concentration p-type semiconductor region 803 is lower than the Fermi level, and the impurity concentration of the high-concentration p-type semiconductor region 803 is a concentration value at which the photoelectrically converted electrons and holes do not recombine. The region having the impurity concentration exceeding the Fermi level is only the high-concentration p-type semiconductor region 46 connected to the anode (contact electrode 52).

The structure around the cathode contact including the separation layer 801 illustrated as a region 831 in the cross-sectional view in A of Fig. 17 will be described.

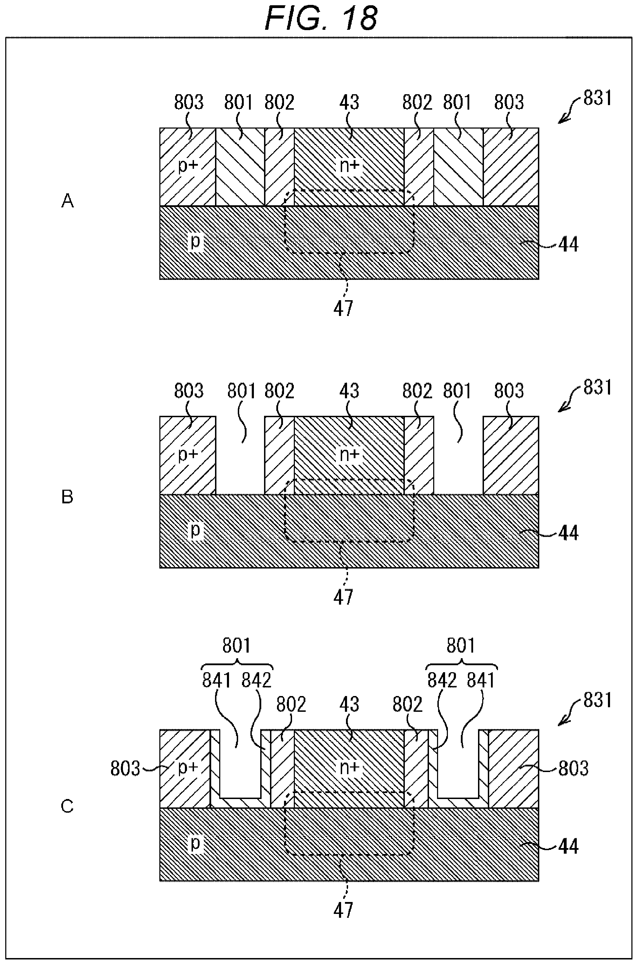

A of Fig. 18 is an enlarged view of the region 831 around the cathode contact in A of Fig. 17.

The separation layer 801 is in contact with the low-concentration n-type semiconductor region 802 on an inner wall surface (inner peripheral wall surface) in the planar direction, and in contact with the high-concentration p-type semiconductor region 803 on an outer wall surface (outer peripheral wall surface) in the planar direction, and physically separates the low-concentration n-type semiconductor region 802 and the high-concentration p-type semiconductor region 803. Thus, as described above, the edge breakdown in the planar direction between the anode and the cathode can be suppressed, and the electrons photoelectrically converted in the region near the front surface of the semiconductor substrate 31 can be moved to the avalanche multiplication region 47, so that the PDE can be improved.

A region in contact with the inner peripheral wall surface of the separation layer 801 is the low-concentration n-type semiconductor region 802 having an impurity concentration lower than that of the high-concentration n-type semiconductor region 43 forming the avalanche multiplication region 47. Thus, the electric field on the inner peripheral wall surface of the separation layer 801 can be relaxed.

Furthermore, the separation layer 801 also has a function of preventing radiation light generated in the avalanche multiplication region 47 from diffusing outward in the planar direction and entering the adjacent pixels 10. Thus, crosstalk caused by the radiation light generated in the avalanche multiplication region 47 can be reduced.

Note that, in the above description, the separation layer 801 is formed by a silicon oxide film, but the separation layer 801 may be formed by another material. For example, the separation layer 801 may be formed by a low-k film having a low dielectric constant. As a specific material of the low-k film, fluorinated silicate glass, parylene, SiOC, Teflon (registered trademark), SiLK, polyimide, fluorinated amorphous carbon, porous silica, or the like may be mentioned.

B and C of Fig. 18 are enlarged views of the region 831 illustrating another configuration example of the separation layer 801.

B of Fig. 18 illustrates an example in which the separation layer 801 is configured by an air gap.

C of Fig. 18 illustrates an example in which the separation layer 801 has a double structure formed by a plurality of materials instead of a single material. The separation layer 801 in C of Fig. 18 has a double structure in which the inside is an air gap 841 and the outside is a silicon oxide film 842. The silicon oxide film 842 is in contact with the low-concentration n-type semiconductor region 802 on an inner wall surface (inner peripheral wall surface) in the planar direction, in contact with the high-concentration p-type semiconductor region 803 on an outer wall surface (outer peripheral wall surface) in the planar direction, and in contact with the p-type semiconductor region 44 on a bottom surface in the downward direction.

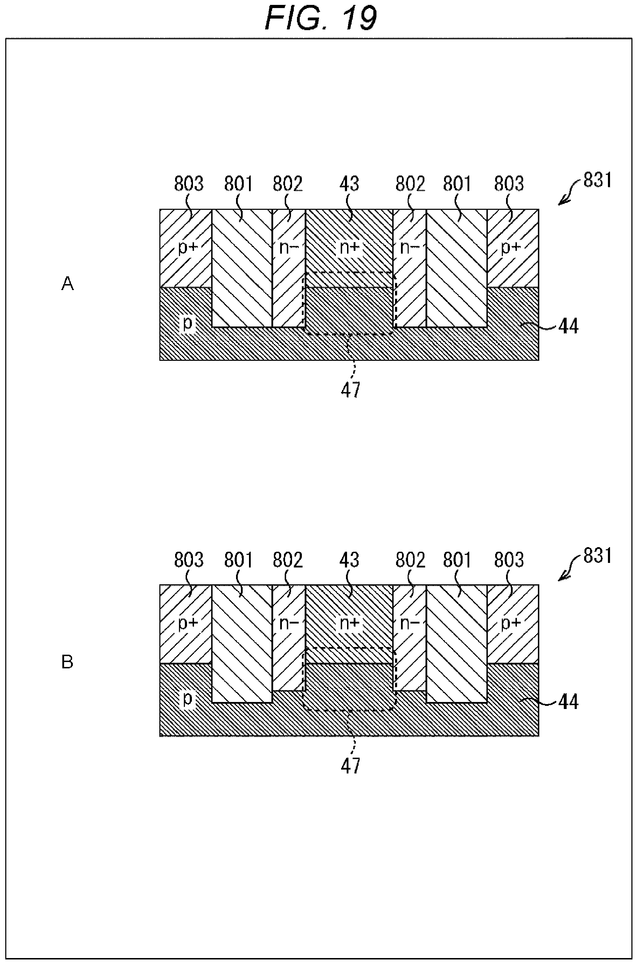

Next, depths of the separation layer 801 and the low-concentration n-type semiconductor region 802 in a substrate thickness direction will be described with reference to Fig. 19.

In the above-described example, the depths of the separation layer 801 and the low-concentration n-type semiconductor region 802 from the substrate front surface are set to the same depth as the pn junction surface of the high-concentration n-type semiconductor region 43 and the p-type semiconductor region 44 in which the avalanche multiplication region 47 is formed, for example, as illustrated in A of Fig. 18.

However, the depth of the separation layer 801 may be set to a position deeper than the pn junction surface as illustrated in A of Fig. 19. The depth of the low-concentration n-type semiconductor region 802 can also be formed at the same depth as the separation layer 801.

Note that the depth of the low-concentration n-type semiconductor region 802 does not need to be formed at the same depth as the separation layer 801, in other words, on the entire inner peripheral wall surface of the separation layer 801, and may be shallower than the separation layer 801 as illustrated in B of Fig. 19. The depth of the low-concentration n-type semiconductor region 802 is only required to be a depth between the depth of the high-concentration n-type semiconductor region 43 on the inside and the depth of the separation layer 801 on the outside. Even in a case where the separation layer 801 is formed with a depth in this range, similar effects to the effects described above can be obtained. For example, it can contribute to suppression of edge breakdown due to physical separation between the n-type semiconductor region and the p-type semiconductor region in the planar direction, reduction of crosstalk caused by the radiation light generated in the avalanche multiplication region 47, and the like.

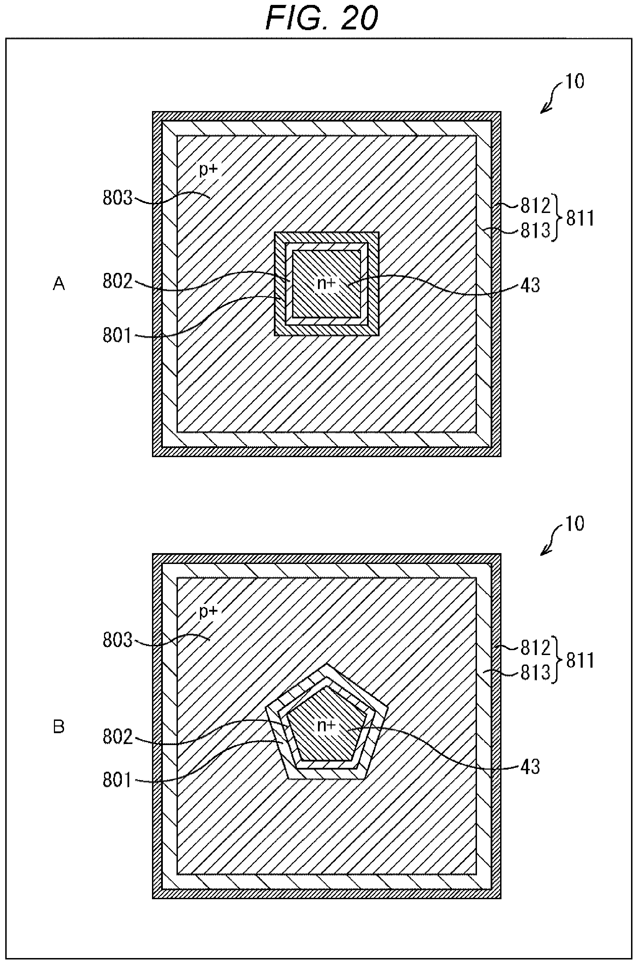

Fig. 20 is a modification example of the pixel 10 according to the seventh pixel structure, and illustrates another example of the planar shape of the high-concentration n-type semiconductor region 43 and the like.

In the example of the seventh pixel structure illustrated in Fig. 16, the planar shapes of the high-concentration n-type semiconductor region 43, the low-concentration n-type semiconductor region 802, and the separation layer 801 are circular shapes, but are not limited to the circular shapes, and may be quadrangular, pentagonal, or other polygonal shapes.

A of Fig. 20 illustrates an example in which the respective planar shapes of the high-concentration n-type semiconductor region 43, the low-concentration n-type semiconductor region 802, and the separation layer 801 are quadrangular shapes.

B of Fig. 20 illustrates an example in which the respective planar shapes of the high-concentration n-type semiconductor region 43, the low-concentration n-type semiconductor region 802, and the separation layer 801 are pentagonal shapes.

### <10. Manufacturing method of seventh pixel structure>

Next, a manufacturing method of the separation layer 801 of the pixel 10 according to the seventh pixel structure will be described.

### <Manufacturing method in case where separation layer is formed by oxide film>

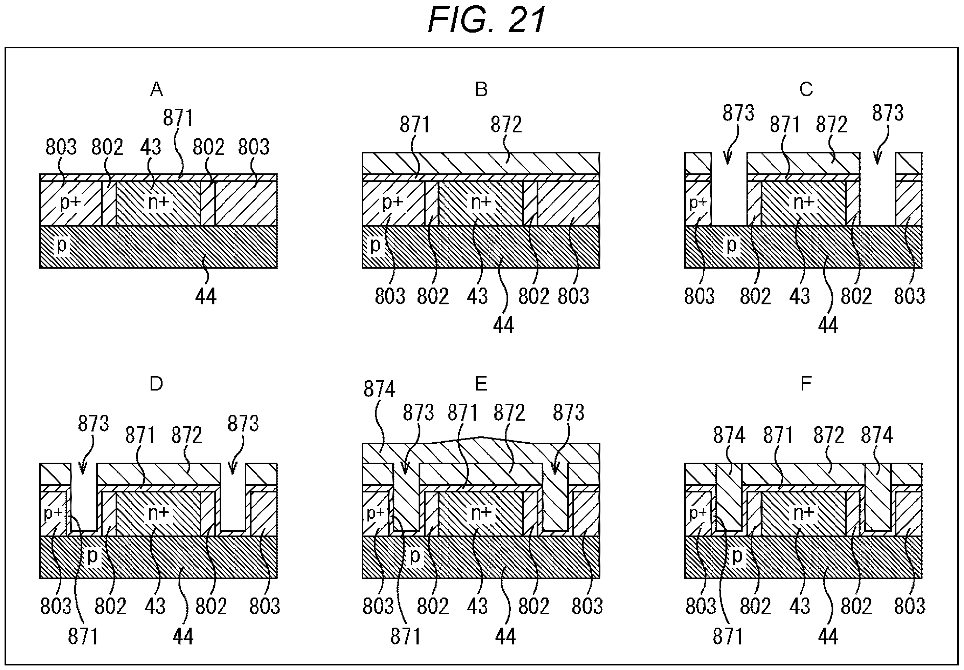

First, a manufacturing method in a case where the separation layer 801 is formed by a silicon oxide film will be described with reference to Fig. 21. Note that Fig. 21 illustrates only a portion corresponding to the region 831 around the cathode contact illustrated in A of Fig. 17.

First, as illustrated in A of Fig. 21, a silicon oxide film 871 is formed as an ion-implanted through film on the upper surface on the front surface side of the semiconductor substrate 31. Thereafter, ion implantation is performed to form the high-concentration n-type semiconductor region 43, the low-concentration n-type semiconductor region 802, and the high-concentration p-type semiconductor region 803 in a region near the front surface side of the semiconductor substrate 31.

Next, as illustrated in B of Fig. 21, a silicon nitride film 872 is formed on the silicon oxide film 871. By etching the high-concentration p-type semiconductor region 803 at a position to be the separation layer 801 using the silicon nitride film 872 as a hard mask, an opening 873 is formed at the formation position of the separation layer 801 as illustrated in C of Fig. 21.

Next, as illustrated in D of Fig. 21, the silicon oxide film 871 is formed on the semiconductor regions of a bottom surface and a side wall surface of the opening 873 by, for example, a thermal oxidation method.

Next, as illustrated in E of Fig. 21, a silicon oxide film 874 is embedded in the opening 873 by, for example, chemical vapor deposition (CVD) using high density plasma. At this time, the silicon oxide film 874 is also formed on an upper surface of the silicon nitride film 872.

Then, as illustrated in F of Fig. 21, the silicon oxide film 874 is planarized by chemical mechanical polishing (CMP) to remove the silicon oxide film 874 formed on the upper surface of the silicon nitride film 872. The silicon oxide film 874 and the silicon oxide film 871 embedded in the opening 873 correspond to the separation layer 801.

Through the above steps, the high-concentration n-type semiconductor region 43, the low-concentration n-type semiconductor region 802, the separation layer 801, and the high-concentration p-type semiconductor region 803 are completed in the region near the front surface side of the semiconductor substrate 31.

### <Manufacturing method in case where separation layer is formed by double structure of air gap and oxide film>

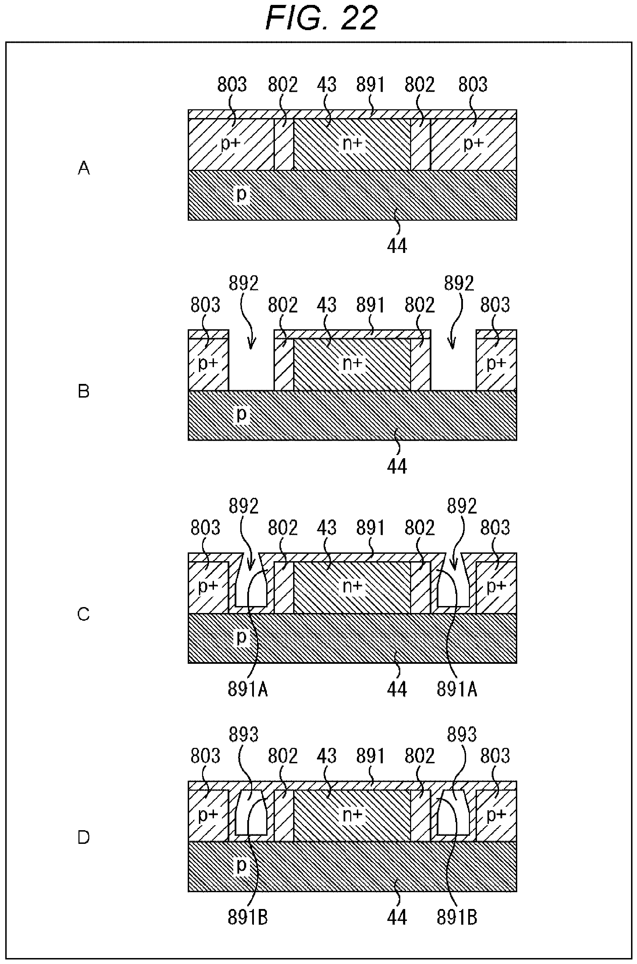

Next, a manufacturing method in a case where the separation layer 801 has a double structure of the air gap 841 and the silicon oxide film 842 will be described with reference to Fig. 22. Note that, in Fig. 22, only a portion corresponding to the region 831 around the cathode contact illustrated in A of Fig. 17 is illustrated.

First, as illustrated in A of Fig. 22, a silicon oxide film 891 is formed as an ion-implanted through film on the upper surface on the front surface side of the semiconductor substrate 31. Thereafter, ion implantation is performed to form the high-concentration n-type semiconductor region 43, the low-concentration n-type semiconductor region 802, and the high-concentration p-type semiconductor region 803 in a region near the front surface side of the semiconductor substrate 31.

Next, as illustrated in B of Fig. 22, dry etching is performed to form an opening 892 at the formation position of the separation layer 801. This step is similar to C of Fig. 21, but is in a state in which a hard mask such as a silicon nitride film is removed.

Next, as illustrated in C of Fig. 22, a silicon oxide film 891A is formed on a bottom surface and a side wall of the opening 892 by, for example, CVD. At this time, the silicon oxide film 891A can be deposited in a step coverage nonuniform manner by adjusting the gas flow rate, and a silicon oxide film 891B is closed and a cavity 893 can be formed as illustrated in D of Fig. 22 by increasing the deposition amount at an upper corner of the opening 892. Thus, the cavity 893 corresponds to the air gap 841 in C of Fig. 18, and the silicon oxide film 891B corresponds to the silicon oxide film 842 in C of Fig. 18.

Through the above steps, the high-concentration n-type semiconductor region 43, the low-concentration n-type semiconductor region 802, the separation layer 801, and the high-concentration p-type semiconductor region 803 are completed in the region near the front surface side of the semiconductor substrate 31.

### <11. Modification example of seventh pixel structure of pixel>

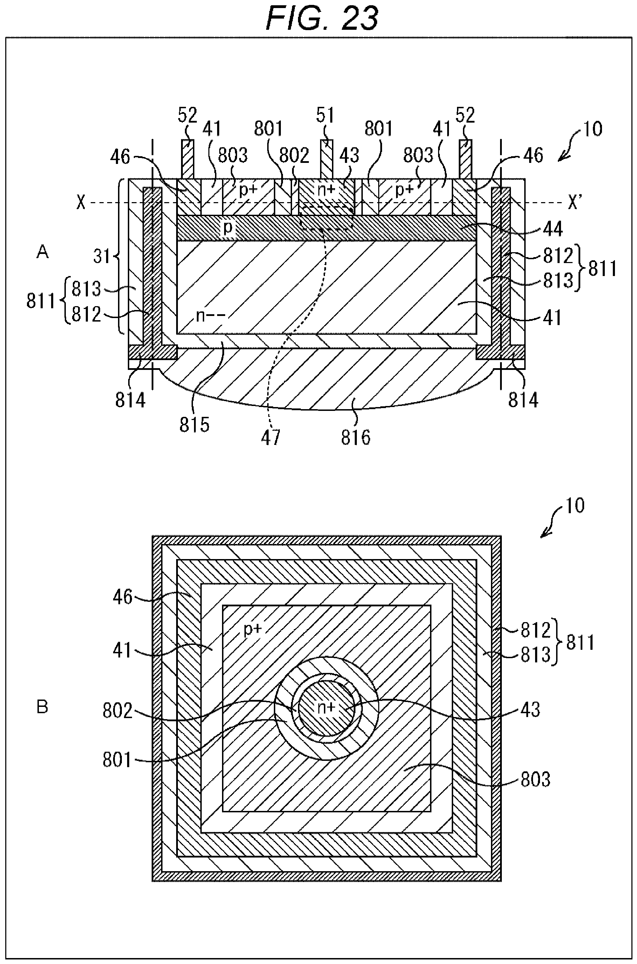

Fig. 23 illustrates a first modification example of the pixel 10 according to the seventh pixel structure.

A of Fig. 23 is a cross-sectional view illustrating the first modification example of the seventh pixel structure, and B of Fig. 23 is a plan view of the pixel 10 taken along line X-X' in A of Fig. 23.

When the first modification example illustrated in Fig. 23 is compared with the pixel 10 according to the seventh pixel structure illustrated in Fig. 16, the formation region of the high-concentration p-type semiconductor region 803 is different, and the other points are common.

That is, in the seventh pixel structure illustrated in Fig. 16, the high-concentration p-type semiconductor region 803 is formed in the entire region in the planar direction from the outer peripheral wall surface of the separation layer 801 to reach the high-concentration p-type semiconductor region 46. On the other hand, in the first modification example of Fig. 23, the high-concentration p-type semiconductor region 803 is reduced to a region from the outer peripheral wall surface of the separation layer 801 to before reaching the high-concentration p-type semiconductor region 46, and the n-well 41 is formed between the high-concentration p-type semiconductor region 803 and the high-concentration p-type semiconductor region 46.

As described above, the high-concentration p-type semiconductor region 803 formed on a substrate front surface side with respect to the p-type semiconductor region 44 is not required to be formed in the entire region in the planar direction between the separation layer 801 and the high-concentration p-type semiconductor region 46. However, the p-type semiconductor region 44 needs to be formed in the entire planar region inside (the silicon oxide film 813 of) the pixel separation portion 811 in order to prevent electrons photoelectrically converted in the n-well 41 from escaping to the substrate front surface side.

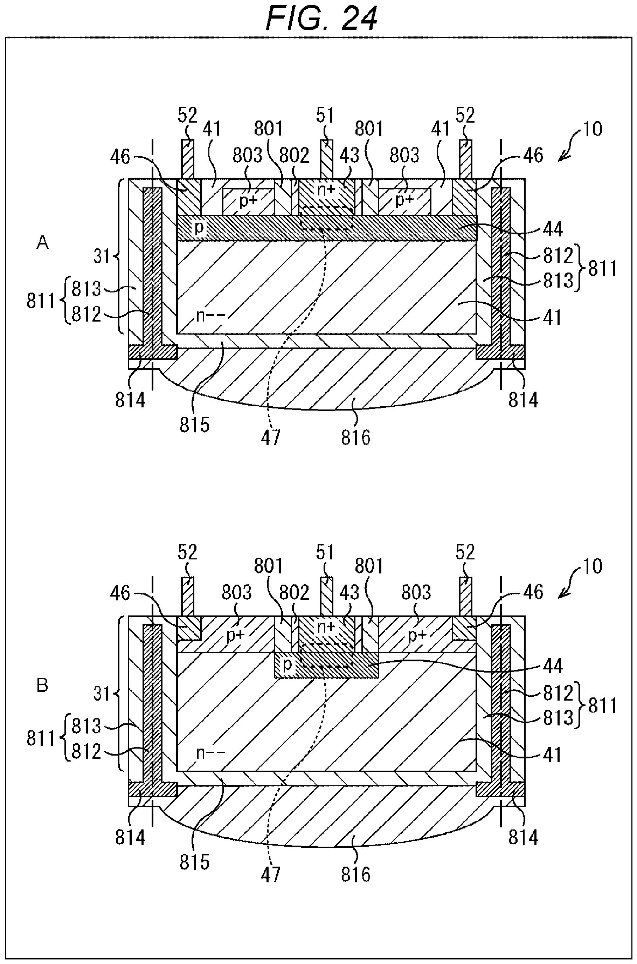

A of Fig. 24 is a cross-sectional view illustrating a second modification example of the pixel 10 according to the seventh pixel structure.

The second modification example illustrated in A of Fig. 24 is the same as the first modification example illustrated in Fig. 23 in that the high-concentration p-type semiconductor region 803 is formed in a region from the outer peripheral wall surface of the separation layer 801 to before reaching the high-concentration p-type semiconductor region 46, and the n-well 41 is formed between the high-concentration p-type semiconductor region 803 and the high-concentration p-type semiconductor region 46.

On the other hand, in the first modification example illustrated in Fig. 23, the high-concentration p-type semiconductor region 803 is formed from an interface on the substrate front surface side to the depth of the p-type semiconductor region 44, whereas in the second modification example illustrated in A of Fig. 24, the high-concentration p-type semiconductor region 803 is not in contact with the interface on the substrate front surface side. In the second modification example, the high-concentration p-type semiconductor region 803 is formed from a predetermined depth position from the interface on the substrate front surface side to the depth of the p-type semiconductor region 44. An n-well 41 is formed in a region from the interface on the substrate front surface side to where the high-concentration p-type semiconductor region 803 is formed. The other points are similar to those of the first modification example illustrated in Fig. 23.

As described above, the high-concentration p-type semiconductor region 803 does not necessarily have to be formed so as to be in contact with the interface on the substrate front surface side. In other words, the high-concentration p-type semiconductor region 803 may be formed in a region buried by a predetermined amount from the interface on the substrate front surface side.

B of Fig. 24 is a cross-sectional view illustrating a third modification example of the pixel 10 according to the seventh pixel structure.

In the third modification example illustrated in B of Fig. 24, the high-concentration p-type semiconductor region 803 is similar to that of the seventh pixel structure illustrated in Fig. 16. That is, the high-concentration p-type semiconductor region 803 is formed in the entire region in the planar direction from the outer peripheral wall surface of the separation layer 801 to reach the high-concentration p-type semiconductor region 46.

On the other hand, in the third modification example in B of Fig. 24, the planar region of the p-type semiconductor region 44 is a region from below the high-concentration n-type semiconductor region 43 forming the avalanche multiplication region 47 to below the separation layer 801, and is not formed in the entire planar region inside the pixel separation portion 811. The other points are similar to those of the seventh pixel structure illustrated in Fig. 16.

As described above, in a case where the high-concentration p-type semiconductor region 803 is formed in the entire region in contact with the interface on the substrate front surface side, the p-type semiconductor region 44 may not be formed in the entire planar region, and may be a planar region of about a lower side of the separation layer 801 centered on the avalanche multiplication region 47.

As described above, if one of the high-concentration p-type semiconductor region 803 and the p-type semiconductor region 44 is formed in the entire planar region inside the pixel separation portion 811 of the pixel 10, the other is not required to be formed in the entire planar region.

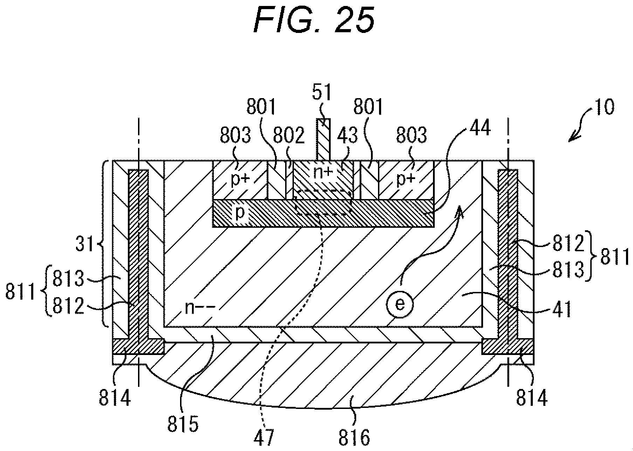

If both the high-concentration p-type semiconductor region 803 and the p-type semiconductor region 44 are not formed in the entire planar region, as illustrated in Fig. 25, electrons photoelectrically converted in the n-well 41 pass through a region where neither the high-concentration p-type semiconductor region 803 nor the p-type semiconductor region 44 is formed and escape to the substrate front surface side. Therefore, by forming at least one of the high-concentration p-type semiconductor region 803 or the p-type semiconductor region 44 in the entire planar region, electrons photoelectrically converted in the n-well 41 can be moved to the avalanche multiplication region 47, and high PDE can be achieved.

### <12. Eighth pixel structure of pixel>

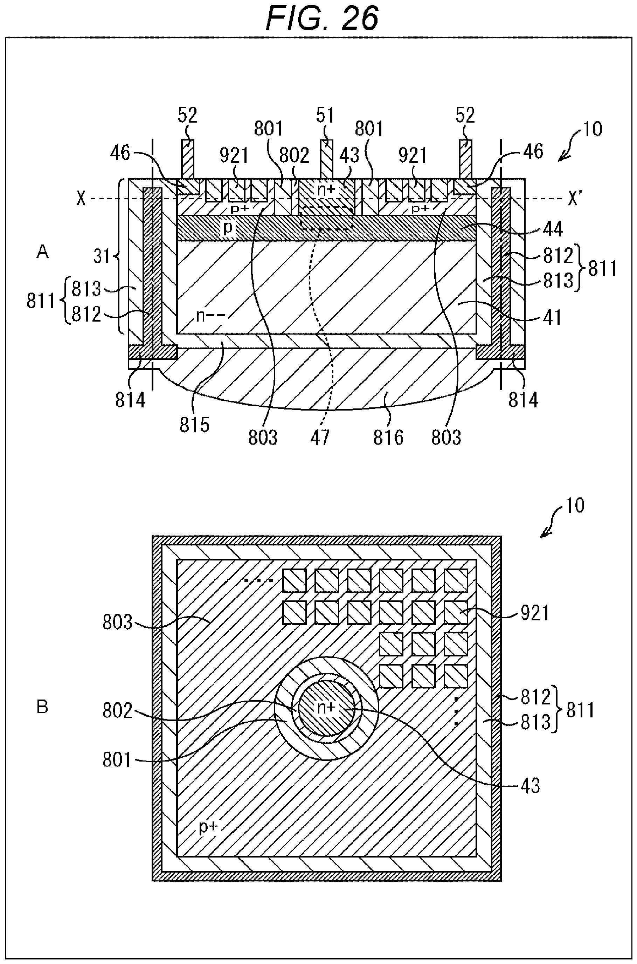

A of Fig. 26 is a cross-sectional view illustrating an eighth pixel structure of the pixel 10 using the SPAD 21, and B of Fig. 26 is a plan view of the pixel 10 taken along line X-X' in A of Fig. 26.

In Fig. 26, the same reference numerals are given to portions common to the seventh pixel structure illustrated in Fig. 16, and the description of the portions will be appropriately omitted.

The pixel 10 according to the eighth pixel structure illustrated in Fig. 26 is different from the seventh pixel structure illustrated in Fig. 16 in further including a reflection structure in the high-concentration p-type semiconductor region 803 formed on the substrate front surface side of the p-type semiconductor region 44, and is common to the seventh pixel structure illustrated in Fig. 16 in other points.

For example, as illustrated in Fig. 26, the reflection structure formed in the high-concentration p-type semiconductor region 803 is configured by arranging a plurality of pillars 921 having a predetermined depth, which do not reach the p-type semiconductor region 44 from the interface of the substrate front surface, in a grid shape at predetermined intervals. In the plan view of B of Fig. 26, the pillars 921 are regularly arranged, and illustration of a part of the pillars 921 is omitted. Note that the plurality of pillars 921 is not necessarily regularly arranged, and may be arranged at random intervals. The pillar 921 can be formed by a material different from the high-concentration p-type semiconductor region 803, for example, the silicon oxide film.

According to the eighth pixel structure, a structure is formed in which two layers having different refractive indexes of the high-concentration p-type semiconductor region 803 and the pillars 921 formed by the silicon oxide film are mixed at the interface on the substrate front surface side, and the light incident on the n-well 41 from the on-chip lens 816 and trying to pass through to the substrate front surface side can be secondarily diffracted and confined in the pixel. Thus, the amount of incident light to be photoelectrically converted in the semiconductor substrate 31 can be further increased, and quantum efficiency (QE) can be improved.

### <13. Ninth pixel structure of pixel>

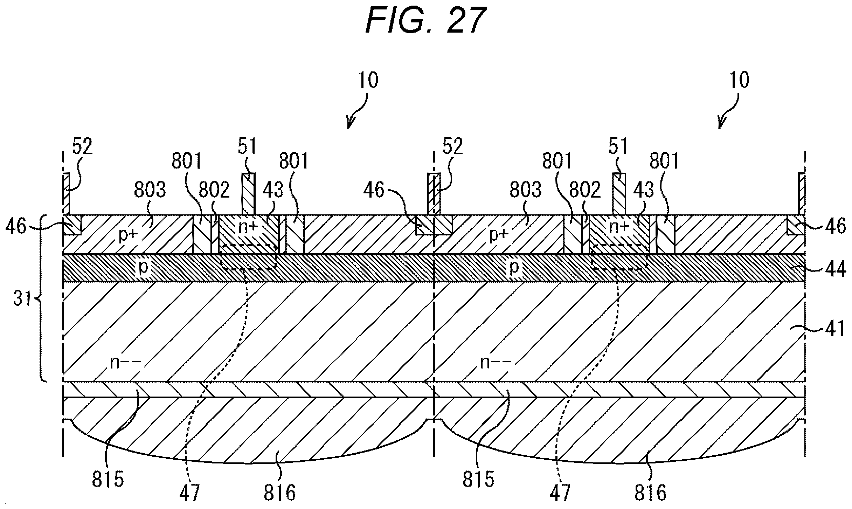

Fig. 27 is a cross-sectional view illustrating a ninth pixel structure of the pixel 10 using the SPAD 21. Fig. 27 illustrates a cross-sectional view of two adjacent pixels, and a one-dot chain line indicates a pixel boundary as in Fig. 16 and the like.

Also in Fig. 27, the same reference numerals are given to portions common to the seventh pixel structure illustrated in Fig. 16, and the description of the portions will be appropriately omitted.

The pixel 10 according to the ninth pixel structure illustrated in Fig. 27 is different from the seventh pixel structure in that the pixel separation portion 811 formed at the pixel boundary portion in the seventh pixel structure illustrated in Fig. 16 is omitted, and is common to the seventh pixel structure illustrated in Fig. 16 in other points.

The pixel 10 illustrated in Fig. 27 includes the separation layer 801 on the outer periphery of the high-concentration n-type semiconductor region 43 forming the avalanche multiplication region 47, so that the influence of the radiation light generated in the avalanche multiplication region 47 can be suppressed. Therefore, as in the ninth pixel structure, the pixel separation portion 811 at the pixel boundary portion may be omitted. Since the pixel separation portion 811 is omitted, absorption of the incident light by the metal DTI 812 constituting the pixel separation portion 811 can be eliminated, so that the PDE can be further improved.

### <14. Tenth pixel structure of pixel>

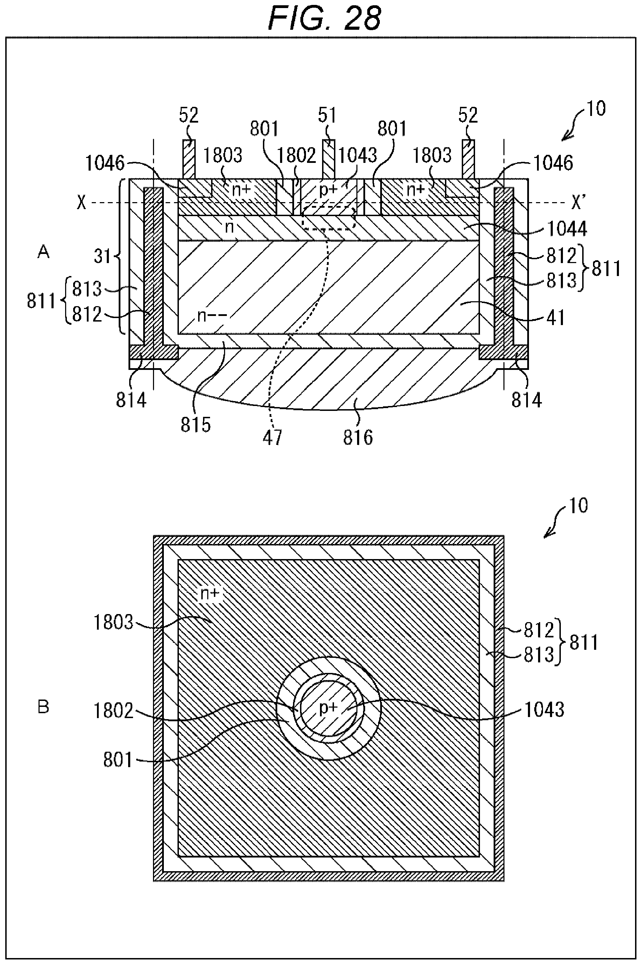

A of Fig. 28 is a cross-sectional view illustrating a tenth pixel structure of the pixel 10 using the SPAD 21, and B of Fig. 28 is a plan view of the pixel 10 taken along line X-X' in A of Fig. 28. Also in Fig. 28, a one-dot chain line indicates a pixel boundary.

Also in Fig. 28, the same reference numerals are given to portions common to the seventh pixel structure illustrated in Fig. 16, and the description of the portions will be appropriately omitted.

A pixel 10 according to a tenth pixel structure illustrated in Fig. 28 has a structure in which the polarity of the pixel 10 according to the seventh pixel structure illustrated in Fig. 16 is inverted. In other words, the pixel 10 according to the seventh pixel structure illustrated in Fig. 16 is an example of a structure in which electrons are read out as signal charges (carriers), but the pixel 10 according to the tenth pixel structure illustrated in Fig. 28 is an example of a structure in which holes are read out as signal charges. In this case, the conductivity types of the semiconductor region connected to the contact electrode 51 as the cathode and the semiconductor region connected to the contact electrode 52 as the anode are opposite.

More specifically, a high-concentration p-type semiconductor region 1043 is formed in the contact electrode 51 as a cathode instead of the high-concentration n-type semiconductor region 43, and a high-concentration n-type semiconductor region 1046 is formed in the contact electrode 52 as an anode instead of the high-concentration p-type semiconductor region 46.

In a plan view of B of Fig. 28, a low-concentration p-type semiconductor region 1802 having an impurity concentration lower than that of the high-concentration p-type semiconductor region 1043 is formed on an outer periphery of the high-concentration p-type semiconductor region 1043. The separation layer 801 is formed on an outer periphery of the low-concentration p-type semiconductor region 1802. On a further outer periphery of the separation layer 801, a high-concentration n-type semiconductor region 1803 is formed instead of the high-concentration p-type semiconductor region 803.

As illustrated in A of Fig. 28, an n-type semiconductor region 1044 is formed with a predetermined thickness in the entire planar region below the formation region of the high-concentration p-type semiconductor region 1043, the low-concentration p-type semiconductor region 1802, the separation layer 801, and the high-concentration n-type semiconductor region 1803, and the avalanche multiplication region 47 is formed by a depletion layer formed in the junction region between the high-concentration p-type semiconductor region 1043 and the n-type semiconductor region 1044 formed therebelow.

Furthermore, the voltage applied from the contact electrode 51 as the cathode to the high-concentration p-type semiconductor region 1043 and the voltage applied from the contact electrode 52 as the anode to the high-concentration n-type semiconductor region 1046 are also opposite. That is, the power supply VSPAD is applied from the contact electrode 51 as the cathode to the high-concentration p-type semiconductor region 1043, and the power supply voltage VE is applied from the contact electrode 52 as the anode to the high-concentration n-type semiconductor region 1046.

Other configurations of the pixel 10 according to the tenth pixel structure in Fig. 28 are similar to those of the pixel 10 according to the seventh pixel structure illustrated in Fig. 16, and thus the description thereof will be omitted.

The effect of the pixel 10 according to the tenth pixel structure in Fig. 28 is similar to the effect described in the seventh pixel structure illustrated in Fig. 16.

As described above, in the description of the first pixel structure illustrated in Fig. 3, it has been described that a signal charge (carrier) can be either an electron or a hole, but this is not limited to the first pixel structure, and either an electron or a hole can be the signal charge in any of the second to ninth pixel structures described above.

### <15. Configuration example of stacked structure>

The light receiving element in which the plurality of pixels 10 using the SPAD 21 is formed can be formed using one semiconductor substrate or can be formed by stacking a plurality of semiconductor substrates.

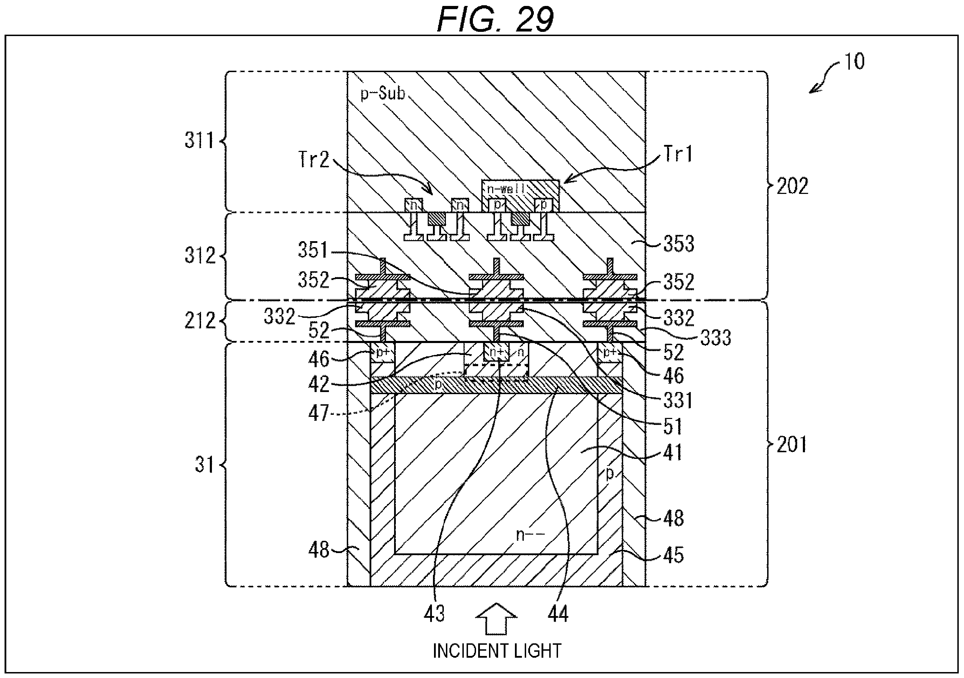

Fig. 29 is a cross-sectional view illustrating an example of a stacked structure in a case where a light receiving element is formed by stacking two semiconductor substrates.

The pixel 10 in Fig. 29 is formed by bonding a first substrate 201 and a second substrate 202. The first substrate 201 includes the semiconductor substrate 31 formed by silicon or the like and a wiring layer 212. On the other hand, the second substrate 202 includes a semiconductor substrate 311 formed by silicon or the like and a wiring layer 312. A bonding surface between the first substrate 201 and the second substrate 202 is indicated by a one-dot chain line.

Hereinafter, the wiring layer 212 will be referred to as a sensor-side wiring layer 212 in order to be easily distinguished from the wiring layer 312 on the second substrate 202 side. The wiring layer 312 on the second substrate 202 side will be referred to as a logic-side wiring layer 312. A surface on which the sensor-side wiring layer 212 is formed with respect to the semiconductor substrate 31 is a front surface, and in the drawing, a lower surface on which the sensor-side wiring layer 212 is not formed is a back surface of the semiconductor substrate 31 and is a light receiving surface on which incident light is incident. Since the structure of the semiconductor substrate 31 is similar to the first pixel structure illustrated in Fig. 3, the description thereof will be omitted.

The sensor-side wiring layer 212 includes a contact electrode 51, a contact electrode 52, a metal pad 331, a metal pad 332, and an interlayer insulating film 333. The metal pad 331 is electrically and physically connected to the metal pad 351 of the logic-side wiring layer 312 by metal bonding such as Cu-Cu. The metal pad 332 is electrically and physically connected to the metal pad 352 of the logic-side wiring layer 312 by metal bonding such as Cu-Cu.

In the drawing, a plurality of MOS transistors Tr (Tr1, Tr2, or the like) and a logic-side wiring layer 312 are formed on a front surface side of the semiconductor substrate 311 which is the lower side. The logic-side wiring layer 312 includes a metal pad 351, a metal pad 352, and an interlayer insulating film 353.

The metal pad 351 is electrically and physically connected to the metal pad 331 of the sensor-side wiring layer 212 by metal bonding of Cu-Cu or the like. The metal pad 352 is electrically and physically connected to the metal pad 332 of the sensor-side wiring layer 212 by metal bonding of Cu-Cu or the like.

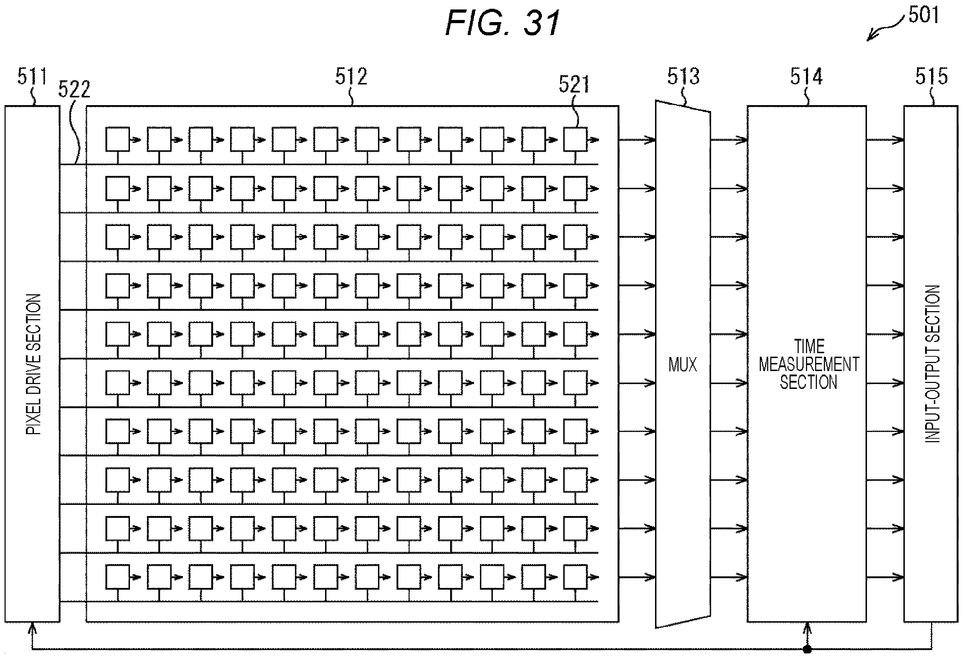

On the second substrate 202, a plurality of MOS transistors Tr formed on the semiconductor substrate 311 and a plurality of layers of metal wiring (not illustrated) form, for example, a readout control circuit that controls signal readout of the pixel 10, such as the constant current source 22, the transistor 23, and the inverter 24 (Fig. 1), and a logic circuit corresponding to a pixel drive section 511, an MUX 513, a time measurement section 514 (Fig. 31), and the like.

With such a wiring structure, for example, the power supply VSPAD supplied to the anode of the SPAD 21 of the pixel 10 is supplied to the high-concentration p-type semiconductor region 46 via the metal pad 352 of the logic-side wiring layer 312, the metal pad 332 of the sensor-side wiring layer 212, and the contact electrode 52. Furthermore, the power supply voltage VE supplied to the cathode of the SPAD 21 of the pixel 10 is supplied to the high-concentration n-type semiconductor region 43 via the metal pad 351 of the logic-side wiring layer 312, the metal pad 331 of the sensor-side wiring layer 212, and the contact electrode 51.

In the example of Fig. 29, an example in which the first pixel structure illustrated in Fig. 3 is employed to have a stacked structure has been described, but it goes without saying that other second to tenth pixel structures can similarly have a stacked structure.

### <16. Pixel circuit that performs active quenching>

The circuit configuration of the pixel 10 illustrated in Fig. 1 is a configuration of a passive circuit that performs passive quenching, but a configuration of an active circuit that performs active quenching, active recharging, and holdoff can also be employed.

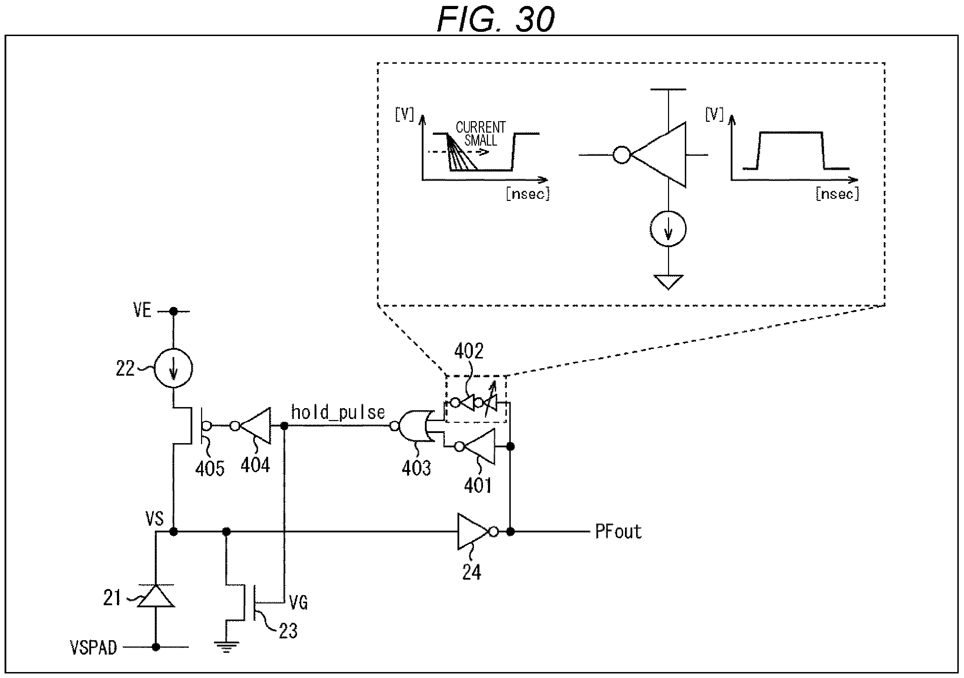

Fig. 30 illustrates a circuit configuration of the pixel 10 as an active circuit that performs active quenching, active recharging, and holdoff.

The pixel 10 in Fig. 30 includes an inverter 401, a variable inverter 402, a NOR circuit 403, an inverter 404, and a P-type MOS transistor 405, in addition to the SPAD 21, the constant current source 22, the transistor 23, and the inverter 24, which are similar to those in Fig. 1.

The detection signal PFout output from the inverter 24 is also input to the inverter 401 and the variable inverter 402. The inverter 401 inverts and outputs the detection signal PFout, and the variable inverter 402 inverts and outputs the detection signal PFout after a predetermined time elapses.

The NOR circuit 403 executes a NOR operation of the inverter 401 and the variable inverter 402, and outputs the execution result to the inverter 404 and the gate of the transistor 23. The inverter 404 inverts the output of the NOR circuit 403 and outputs the inverted output to the gate of the P-type MOS transistor.

In the pixel 10 of Fig. 30, avalanche multiplication occurs, and after a predetermined time determined by the variable inverter 402 has elapsed since an output of the Hi detection signal PFout, a hold pulse (hold_pulse) output from the NOR circuit 403 becomes Hi. By the Hi hold pulse, the transistor 23 is turned on and connected to GND to perform active quenching, and the P-type MOS transistor 405 is turned on to maintain (hold off) the cathode voltage VS at 0 V (GND).

When the hold pulse of Hi is controlled to be Lo by a hold control circuit which is not illustrated after the hold pulse of Hi is held for a predetermined time, the transistor 23 and the P-type MOS transistor 405 are turned off, so that the cathode voltage VS returns to the original power supply voltage VE again, making it capable of detecting a next new photon (active recharging operation).

As in the case of the passive circuit of Fig. 1, the control of setting the pixel 10 as the active pixel or the inactive pixel is performed by the hold control circuit, which is not illustrated, controlling the hold pulse to turn on and off the transistor 23.

The inverter 401, the variable inverter 402, the NOR circuit 403, the inverter 404, and the P-type MOS transistor 405 for performing active quenching and active recharging are a part of a readout control circuit that controls signal reading of the pixel 10.

### <17. Configuration example of light receiving element>

The pixel 10 according to the first to tenth pixel structures described above can be applied to, for example, the pixel of the light receiving element illustrated in Fig. 31.

Fig. 31 is a block diagram of a light receiving element including the pixel 10 described above.

The light receiving element 501 in Fig. 31 includes a pixel drive section 511, a pixel array 512, a multiplexer (MUX) 513, a time measurement section 514, and an input-output section 515.

The pixel array 512 has a configuration in which pixels 521 that detect incidence of photons and output the detection signal PFout indicating a detection result as a pixel signal are two-dimensionally arranged in a matrix in a row direction and a column direction. Here, the row direction refers to the arrangement direction of the pixels 521 in the pixel row, that is, the horizontal direction, and the column direction refers to the arrangement direction of the pixels 521 in the pixel column, that is, the vertical direction. In Fig. 31, the pixel array 512 is illustrated in a pixel array configuration of 10 rows and 12 columns due to paper surface restriction, but the number of rows and the number of columns of the pixel array 512 are not limited thereto and are arbitrary.

The pixel drive line 522 is wired along the horizontal direction for each pixel row with respect to the matrix-like pixel array of the pixel array 512. The pixel drive line 522 transmits a drive signal for driving the pixels 521. The pixel drive section 511 drives each pixel 521 by supplying a predetermined drive signal to each pixel 521 via the pixel drive line 522. Specifically, the pixel drive section 511 performs control such that a part of the pixels 521 among the plurality of pixels 521 two-dimensionally arranged in a matrix form are set as active pixels and the remaining pixels 521 are set as inactive pixels at a predetermined timing corresponding to a light emission timing signal supplied from the outside via the input-output section 515. The active pixel is a pixel that detects incidence of photons, and the inactive pixel is a pixel that does not detect incidence of photons. As the configuration of the pixel 521, any one of the first to tenth pixel structures of the pixel 10 described above can be employed.

Note that, in Fig. 31, the pixel drive line 522 is illustrated as one wiring, but may include a plurality of wirings. One end of the pixel drive line 522 is connected to an output terminal corresponding to each pixel row of the pixel drive section 511.

The MUX 513 selects an output from the active pixel according to switching between the active pixel and the inactive pixel in the pixel array 512. Then, the MUX 513 outputs the pixel signal input from the selected active pixel to the time measurement section 514.

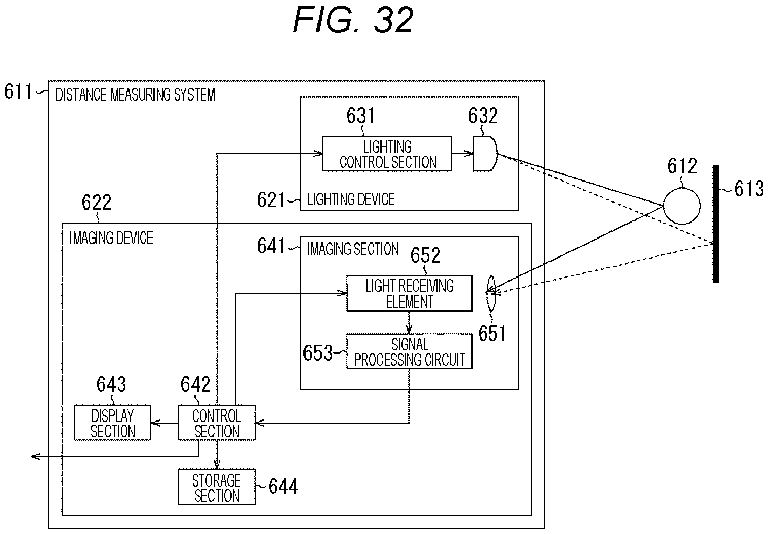

On the basis of the pixel signal of the active pixel supplied from the MUX 513 and the light emission timing signal indicating the light emission timing of the light emitting source (a light source 632 in Fig. 32), the time measurement section 514 generates a count value corresponding to the time from when the light emitting source emits light to when the active pixel receives the light. The light emission timing signal is supplied from the outside (a control section 642 of an imaging device 622 in Fig. 32) via the input-output section 515.

The input-output section 515 outputs the count value of the active pixel supplied from the time measurement section 514 to the outside (a signal processing circuit 653 in Fig. 32) as a pixel signal. Furthermore, the input-output section 515 supplies the light emission timing signal supplied from the outside to the pixel drive section 511 and the time measurement section 514.

### <18. Configuration example of distance measuring system>

Fig. 32 is a block diagram illustrating a configuration example of an embodiment of a distance measuring system in which the light receiving element 501 of Fig. 31 is incorporated.

The distance measuring system 611 is, for example, a system that captures a distance image using the ToF method. Here, the distance image is an image formed by a distance pixel signal based on a detected distance by detecting a distance in a depth direction from the distance measuring system 611 to the subject for each pixel.

The distance measuring system 611 includes a lighting device 621 and an imaging device 622.

The lighting device 621 includes a lighting control section 631 and a light source 632.

The lighting control section 631 controls a pattern in which the light source 632 emits light under the control of the control section 642 of the imaging device 622. Specifically, the lighting control section 631 controls a pattern in which the light source 632 emits light according to an irradiation code included in the irradiation signal supplied from the control section 642. For example, the irradiation code has two values of 1 (High) and 0 (Low), and the lighting control section 631 turns on the light source 632 when the value of the irradiation code is 1 and turns off the light source 632 when the value of the irradiation code is 0.

The light source 632 emits light in a predetermined wavelength region under the control of the lighting control section 631. The light source 632 includes, for example, an infrared laser diode. Note that the type of the light source 632 and the wavelength range of the irradiation light can be arbitrarily set according to the application of the distance measuring system 611 and the like.

The imaging device 622 is a device that receives reflected light obtained by reflecting light (irradiation light) emitted from the lighting device 621 by the subject 612, the subject 613, and the like. The imaging device 622 includes an imaging section 641, a control section 642, a display section 643, and a storage section 644.

The imaging section 641 includes a lens 651, a light receiving element 652, and a signal processing circuit 653.

The lens 651 forms an image of the incident light on the light receiving surface of the light receiving element 652. Note that the configuration of the lens 651 is arbitrary, and for example, the lens 651 can be configured by a plurality of lens groups.

The light receiving element 652 includes, for example, a sensor using a SPAD for each pixel. Under the control of the control section 642, the light receiving element 652 receives reflected light from the subject 612, the subject 613, and the like, and supplies a pixel signal obtained as a result to the signal processing circuit 653. This pixel signal represents a digital count value obtained by counting a time from when the lighting device 621 emits the irradiation light to when the light receiving element 652 receives the irradiation light. The light emission timing signal indicating the timing at which the light source 632 emits light is also supplied from the control section 642 to the light receiving element 652. As a configuration of the light receiving element 652, the light receiving element 501 in Fig. 31 including the pixel 10 described above is employed.

The signal processing circuit 653 processes the pixel signal supplied from the light receiving element 652 under the control of the control section 642. For example, the signal processing circuit 653 detects the distance to the subject for each pixel on the basis of the pixel signal supplied from the light receiving element 652, and generates a distance image indicating the distance to the subject for each pixel. Specifically, the signal processing circuit 653 acquires a time (count value) from when the light source 632 emits light to when each pixel of the light receiving element 652 receives the light a plurality of times (for example, several thousands to several tens of thousands of times) for each pixel. The signal processing circuit 653 creates a histogram corresponding to the acquired time. Then, by detecting a peak of the histogram, the signal processing circuit 653 determines the time until the light emitted from the light source 632 is reflected by the subject 612 or the subject 613 and returns. Moreover, the signal processing circuit 653 performs an arithmetic operation to obtain the distance to the object on the basis of the determined time and light speed. The signal processing circuit 653 supplies the generated distance image to the control section 642.

The control section 642 includes, for example, a control circuit such as a field programmable gate array (FPGA) or a digital signal processor (DSP), a processor, and the like. The control section 642 controls the lighting control section 631 and the light receiving element 652. Specifically, the control section 642 supplies an irradiation signal to the lighting control section 631 and supplies a light emission timing signal to the light receiving element 652. The light source 632 emits irradiation light according to the irradiation signal. The light emission timing signal may be an irradiation signal supplied to the lighting control section 631. Furthermore, the control section 642 supplies the distance image acquired from the imaging section 641 to the display section 643 and causes the display section 643 to display the distance image. Moreover, the control section 642 stores the distance image acquired from the imaging section 641 in the storage section 644. Furthermore, the control section 642 outputs the distance image acquired from the imaging section 641 to the outside.

The display section 643 includes, for example, a panel type display device such as a liquid crystal display device or an organic electro luminescence (EL) display device.

The storage section 644 can include an arbitrary storage device, a storage medium, or the like, and stores a distance image or the like.

By employing the above structure of the pixel 10 in the light receiving element 501 and the distance measuring system 611 described above, it is possible to generate and output a distance image achieving the high PDE (photon detection efficiency) while preventing edge break.

### <19. Application Example to Electronic Device>

The above-described distance measuring system 611 can be mounted, for example, on electronic devices such as a smartphone, a tablet terminal, a mobile phone, a personal computer, a game machine, a television receiver, a wearable terminal, a digital still camera, and a digital video camera.

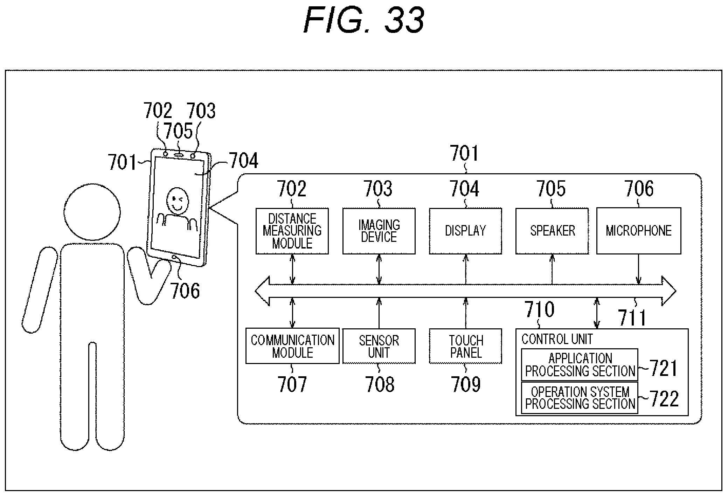

Fig. 33 is a block diagram illustrating a configuration example of a smartphone as an electronic device equipped with the distance measuring system 611.

As illustrated in Fig. 33, a smartphone 701 is configured by connecting a distance measuring module 702, an imaging device 703, a display 704, a speaker 705, a microphone 706, a communication module 707, a sensor unit 708, a touch panel 709, and a control unit 710 via a bus 711. Furthermore, the control unit 710 has functions as an application processing section 721 and an operation system processing section 722 by the CPU executing a program.

The distance measuring system 611 in Fig. 32 is applied to the distance measuring module 702. For example, the distance measuring module 702 is arranged in front of the smartphone 701, and performs distance measurement for the user of the smartphone 701, so that the depth value of the surface shape of the face, hand, finger, or the like of the user can be output as a distance measurement result.

The imaging device 703 is arranged in front of the smartphone 701 and performs imaging with the user of the smartphone 701 being a subject, to thereby acquire an image in which the user is captured. Note that, although not illustrated, the imaging device 703 may also be arranged on the back surface of the smartphone 701.

The display 704 displays an operation screen for performing processing by the application processing section 721 and the operation system processing section 722, an image captured by the imaging device 703, and the like. The speaker 705 and the microphone 706 output the voice of the other party and collect the voice of the user, for example, when making a call using the smartphone 701.

The communication module 707 performs communication via a communication network. The sensor unit 708 senses speed, acceleration, proximity, and the like, and the touch panel 709 acquires a touch operation by the user on an operation screen displayed on the display 704.

The application processing section 721 performs processing for providing various services by the smartphone 701. For example, the application processing section 721 can perform processing of creating a face by computer graphics that virtually reproduces the expression of the user on the basis of the depth map supplied from the distance measuring module 702, and displaying the face on the display 704. Furthermore, the application processing section 721 can perform processing of creating three-dimensional shape data of an arbitrary three-dimensional object on the basis of the depth map supplied from the distance measuring module 702, for example.

The operation system processing section 722 performs processing for achieving basic functions and operations of the smartphone 701. For example, the operation system processing section 722 can perform processing of authenticating the user's face and unlocking the smartphone 701 on the basis of the depth map supplied from the distance measuring module 702. Furthermore, the operation system processing section 722 can perform, for example, processing of recognizing a gesture of the user on the basis of the depth map supplied from the distance measuring module 702 and processing of inputting various operations according to the gesture.

In the smartphone 701 configured as described above, for example, the depth map can be generated with high accuracy and high speed by applying the above-described distance measuring system 1. Thus, the smartphone 701 can more accurately detect distance measurement information.

### <20. Application example to mobile object>

The technology according to the present disclosure (the present technology) can be applied to various products. For example, the technology according to the present disclosure may be achieved as a device mounted on any type of mobile object such as an automobile, an electric vehicle, a hybrid electric vehicle, a motorcycle, a bicycle, a personal mobility, an airplane, a drone, a ship, a robot, and the like.

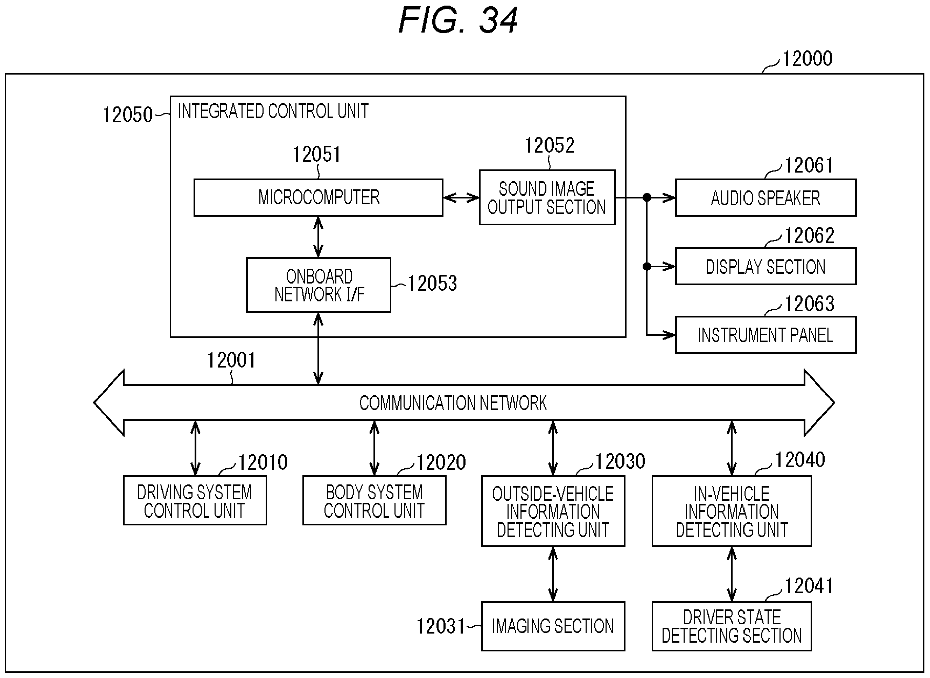

Fig. 34 is a block diagram illustrating a schematic configuration example of a vehicle control system as an example of a mobile body control system to which the technology according to the present disclosure can be applied.

A vehicle control system 12000 includes a plurality of electronic control units connected via a communication network 12001. In the example illustrated in Fig. 34, the vehicle control system 12000 includes a driving system control unit 12010, a body system control unit 12020, an outside-vehicle information detecting unit 12030, an in-vehicle information detecting unit 12040, and an integrated control unit 12050. Furthermore, as a functional configuration of the integrated control unit 12050, a microcomputer 12051, a sound/image output section 12052, and an onboard network interface (I/F) 12053 are illustrated.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls operation of various devices mounted on the vehicle body according to various programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control for the purpose of achieving functions of the advanced driver assistance system (ADAS) including vehicle collision avoidance or impact mitigation, following traveling based on an inter-vehicle distance, vehicle speed maintaining traveling, vehicle collision warning, or vehicle lane departure warning, and the like.

In addition, the microcomputer 12051 can perform cooperative control intended for automated driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control for the purpose of anti-glare, such as controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound or an image to an output device capable of visually or auditorily notifying an occupant of the vehicle or the outside of the vehicle of information. In the example of Fig. 34, an audio speaker 12061, a display section 12062, and an instrument panel 12063 are illustrated as the output device. The display section 12062 may, for example, include at least one of an on-board display or a head-up display.

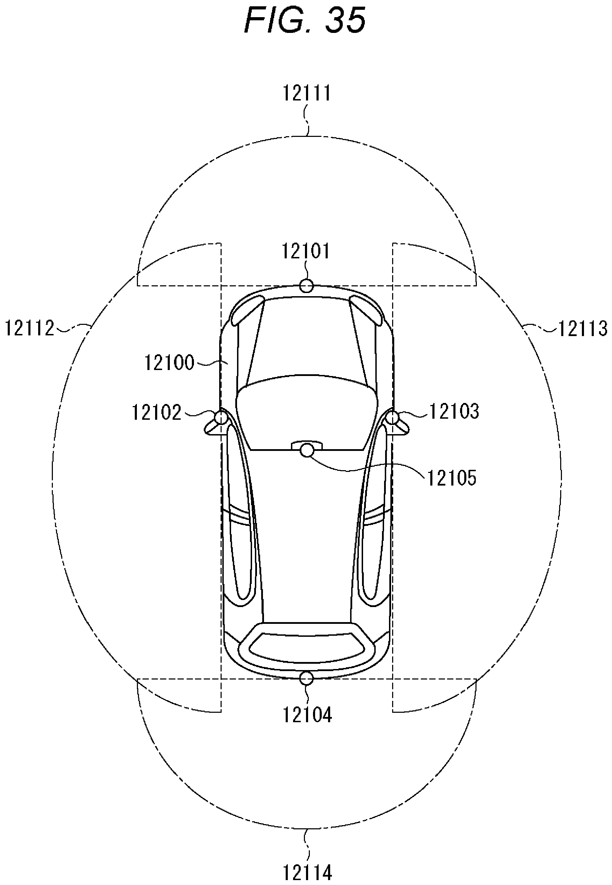

Fig. 35 is a diagram illustrating an example of the installation position of the imaging section 12031.

In Fig. 35, the vehicle 12100 includes imaging sections 12101, 12102, 12103, 12104, and 12105 as the imaging section 12031.

The imaging sections 12101, 12102, 12103, 12104, and 12105 are provided, for example, at positions such as a front nose, a side mirror, a rear bumper, a back door, and an upper part of a windshield in the cabin of the vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided in the side mirrors mainly obtain images of sides of the vehicle 12100. The imaging section 12104 provided to the rear bumper or the back door obtains mainly an image of the rear of the vehicle 12100. The forward image obtained by the imaging sections 12101 and 12105 are mainly used for detecting a preceding vehicle, a pedestrian, an obstacle, a traffic light, a traffic sign, a lane, and the like.

Incidentally, Fig. 35 illustrates an example of photographing ranges of the imaging sections 12101 to 12104. An imaging range 12111 represents the imaging range of the imaging section 12101 provided on the front nose, imaging ranges 12112 and 12113 represent the imaging ranges of the imaging sections 12102 and 12103 provided on the side mirrors, respectively, and an imaging range 12114 represents the imaging range of the imaging section 12104 provided in the rear bumper or the back door. For example, by overlaying image data captured by the imaging sections 12101 to 12104, an overhead image of the vehicle 12100 viewed from above can be obtained.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects, and the like on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating the risk of collision with each obstacle, and when the collision risk is equal to or higher than a set value and there is a possibility of collision, the microcomputer 12051 can output a warning to the driver via the audio speaker 12061 and the display section 12062, or perform forced deceleration or avoidance steering via the driving system control unit 12010, to thereby perform assistance in driving for collision avoidance.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The example of the vehicle control system to which the technology according to the present disclosure can be applied has been described above. The technology according to the present disclosure can be applied to the outside-vehicle information detecting unit 12030 and the in-vehicle information detecting unit 12040 among the above-described configurations. Specifically, by using distance measurement by the distance measuring system 1 as the outside-vehicle information detecting unit 12030 and the in-vehicle information detecting unit 12040, it is possible to perform processing of recognizing a gesture of the driver, execute various operations (for example, an audio system, a navigation system, and an air conditioning system) according to the gesture, and more accurately detect the state of the driver. In addition, the unevenness of the road surface can be recognized using the distance measurement by the distance measuring system 1 and reflected in the control of the suspension.

The embodiments of the present technology are not limited to the above-described embodiments, and various modifications are possible without departing from the gist of the present technology.

The plurality of present technologies which has been described in the present description can be each implemented independently as a single unit as long as no contradiction occurs. Of course, any plurality of the present technologies can also be used and implemented in combination. Furthermore, part or all of any of the above-described present technologies can be implemented by using together with another technology that is not described above.

Further, for example, a configuration described as one device (or processing unit) may be divided and configured as a plurality of devices (or processing units). Conversely, configurations described above as a plurality of devices (or processing units) may be combined and configured as one device (or processing unit). Furthermore, a configuration other than those described above may of course be added to the configuration of each device (or each processing unit). Moreover, if the configuration and operation of the entire system are substantially the same, a part of the configuration of a certain device (or processing unit) may be included in the configuration of another device (or another processing unit).

Moreover, in the present description, a system means a set of a plurality of components (devices, modules (parts), and the like), and it does not matter whether or not all components are in the same housing. Therefore, both of a plurality of devices housed in separate housings and connected via a network and a single device in which a plurality of modules is housed in one housing are systems.

Note that the effects described in the present description are merely examples and are not limited, and effects other than those described in the present description may be provided.

Note that the present technology can have the following configurations.
(1) A light receiving element including
   a pixel in which a multiplication region is formed in a region where a first semiconductor region of a first conductivity type and a second semiconductor region of a second conductivity type opposite to the first semiconductor region are joined, and a planar region of the second semiconductor region formed at a position closer to a light receiving surface than the first semiconductor region is formed to be larger.
(2) The light receiving element according to (1) above, in which
   the pixel further includes a third semiconductor region of the second conductivity type on a surface opposite to the light receiving surface and a side surface near a boundary portion of the pixel.
(3) The light receiving element according to (2) above, in which
   the second semiconductor region is formed up to the third semiconductor region formed on the side surface near the boundary portion of the pixel.
(4) The light receiving element according to (2) or (3) above, further including
   a fourth semiconductor region of the first conductivity type provided between the second semiconductor region and the third semiconductor region formed on the side surface near the boundary portion of the pixel.
(5) The light receiving element according to any one of (2) to (4) above, in which
   the pixel further includes a fixed charge film having a fixed charge on a surface outside the third semiconductor region.
(6) The light receiving element according to any one of (2) to (5) above, in which
   the pixel further includes a pixel separation portion that separates pixels from each other at the pixel boundary portion outside the third semiconductor region.
(7) The light receiving element according to (6) above, in which
   a predetermined voltage is applied to the pixel separation portion.
(8) The light receiving element according to any one of (2) to (7) above, further including
   a separation layer electrically separating a first contact portion of the first semiconductor region connected to one electrode of an anode or a cathode and a second contact portion of the third semiconductor region connected to the other electrode between the first contact portion and the second contact portion.
(9) The light receiving element according to (8) above, further including
   a fifth semiconductor region of the second conductivity type provided between the separation layer and the third semiconductor region.
(10) The light receiving element according to (8) or (9) above, further including
   a sixth semiconductor region having a same conductivity type as the first semiconductor region and a lower impurity concentration than the first semiconductor region between the first semiconductor region and the separation layer.
(11) The light receiving element according to (9) above, further including
   a reflection structure formed by a material different from a material of the fifth semiconductor region in a region of the fifth semiconductor region.
(12) The light receiving element according to any one of (2) to (8) above, in which
   a first contact portion of the first semiconductor region connected to one electrode of an anode or a cathode and a second contact portion of the third semiconductor region connected to the other electrode are arranged at different depth positions.
(13) The light receiving element according to any one of (1) to (8) above, further including
   a fourth semiconductor region of the first conductivity type and a fifth semiconductor region having a same conductivity type as the fourth semiconductor region and a lower impurity concentration than the fourth semiconductor region at a position closer to the light receiving surface than the second semiconductor region.
(14) The light receiving element according to any one of (1) to (8) above, further including
   a fourth semiconductor region having a same conductivity type as the second semiconductor region and a lower impurity concentration than the second semiconductor region, and a fifth semiconductor region having a different conductivity type from the fourth semiconductor region at a position closer to the light receiving surface than the second semiconductor region.
(15) The light receiving element according to any one of (1) to (14) above, in which
   a planar shape of the first semiconductor region is a circular shape.
(16) The light receiving element according to any one of (1) to (15) above, in which
   a diameter of the first semiconductor region is 2 um or less.
(17) The light receiving element according to any one of (1) to (16) above, in which
   a relative distance in a depth direction of the first semiconductor region and the second semiconductor region is 1000 nm or less.
(18) The light receiving element according to any one of (1) to (17) above, in which
   an impurity concentration of each of the first semiconductor region and the second semiconductor region is 1E + 16/cm³ or more.
(19) The light receiving element according to any one of (1) to (18) above, in which
   the light receiving element has a stacked structure in which a first semiconductor substrate and a second semiconductor substrate are stacked,
   the first semiconductor region and the second semiconductor region are formed in the first semiconductor substrate, and
   a readout control circuit that controls signal reading of the pixel is formed on the second semiconductor substrate.
(20) A distance measuring system including:
   a lighting device that emits irradiation light; and
   a light receiving element that receives reflected light obtained by reflecting the irradiation light by a subject, in which
   the light receiving element includes
   a pixel in which a multiplication region is formed in a region where a first semiconductor region of a first conductivity type and a second semiconductor region of a second conductivity type opposite to the first semiconductor region are joined, a planar region of the second semiconductor region is formed to be larger, and a planar region of the second semiconductor region formed at a position closer to a light receiving surface than the first semiconductor region is formed to be larger.

### REFERENCE SIGNS LIST

- 10: Pixel
- 21: SPAD
- 22: Constant current source
- 23: Transistor
- 24: Inverter
- 31: Semiconductor substrate
- 41: n-well
- 42: n-type semiconductor region
- 43: High-concentration n-type semiconductor region
- 44, 44': p-type semiconductor region
- 45: Hole accumulation region
- 46: High-concentration p-type semiconductor region
- 47: Avalanche multiplication region
- 48: Pixel separation portion
- 101: Inter-pixel trench portion
- 102: Insulating layer
- 121: Fixed charge film
- 141: Insulating layer
- 161: Conductive member
- 162: Insulating film
- 201: First substrate
- 202: Second substrate
- 311: Semiconductor substrate
- 401: Inverter
- 402: Variable inverter
- 403: NOR circuit
- 404: Inverter
- 405: MOS transistor
- 501: Light receiving element
- 521: Pixel
- 611: Distance measuring system
- 621: Lighting device
- 622: Imaging device
- 652: Light receiving element
- 701: Smartphone
- 702: Distance measuring module
- 801: Separation layer
- 802: Low-concentration n-type semiconductor region
- 803: High-concentration p-type semiconductor region
- 811: Pixel separation portion
- 812: Metal DTI
- 813: Silicon oxide film
- 816: On-chip lens
- 841: Air gap
- 842: Silicon oxide film
- 921: Pillar

## Claims

1. A light receiving element comprising
a pixel in which a multiplication region is formed in a region where a first semiconductor region of a first conductivity type and a second semiconductor region of a second conductivity type opposite to the first semiconductor region are joined, and a planar region of the second semiconductor region formed at a position closer to a light receiving surface than the first semiconductor region is formed to be larger.

2. The light receiving element according to claim 1, wherein
the pixel further includes a third semiconductor region of the second conductivity type on the light receiving surface and a side surface near a boundary portion of the pixel.

3. The light receiving element according to claim 2, wherein
the second semiconductor region is formed up to the third semiconductor region formed on the side surface near the boundary portion of the pixel.

4. The light receiving element according to claim 2, further comprising
a fourth semiconductor region of the first conductivity type provided between the second semiconductor region and the third semiconductor region formed on the side surface near the boundary portion of the pixel.

5. The light receiving element according to claim 2, wherein
the pixel further includes a fixed charge film having a fixed charge on a surface outside the third semiconductor region.

6. The light receiving element according to claim 2, wherein
the pixel further includes a pixel separation portion that separates pixels from each other at the pixel boundary portion outside the third semiconductor region.

7. The light receiving element according to claim 6, wherein
a predetermined voltage is applied to the pixel separation portion.

8. The light receiving element according to claim 2, further comprising
a separation layer electrically separating a first contact portion of the first semiconductor region connected to one electrode of an anode or a cathode and a second contact portion of the third semiconductor region connected to the other electrode between the first contact portion and the second contact portion.4

9. The light receiving element according to claim 8, further comprising
a fifth semiconductor region of the second conductivity type provided between the separation layer and the third semiconductor region.

10. The light receiving element according to claim 8, further comprising
a sixth semiconductor region having a same conductivity type as the first semiconductor region and a lower impurity concentration than the first semiconductor region between the first semiconductor region and the separation layer.

11. The light receiving element according to claim 9, further comprising
a reflection structure formed by a material different from a material of the fifth semiconductor region in a region of the fifth semiconductor region.

12. The light receiving element according to claim 2, wherein
a first contact portion of the first semiconductor region connected to one electrode of an anode or a cathode and a second contact portion of the third semiconductor region connected to the other electrode are arranged at different depth positions.

13. The light receiving element according to claim 1, further comprising
a fourth semiconductor region of the first conductivity type and a fifth semiconductor region having a same conductivity type as the fourth semiconductor region and a lower impurity concentration than the fourth semiconductor region at a position closer to the light receiving surface than the second semiconductor region.

14. The light receiving element according to claim 1, further comprising
a fourth semiconductor region having a same conductivity type as the second semiconductor region and a lower impurity concentration than the second semiconductor region, and a fifth semiconductor region having a different conductivity type from the fourth semiconductor region at a position closer to the light receiving surface than the second semiconductor region.

15. The light receiving element according to claim 1, wherein
a planar shape of the first semiconductor region is a circular shape.

16. The light receiving element according to claim 1, wherein
a diameter of the first semiconductor region is 2 um or less.

17. The light receiving element according to claim 1, wherein
a relative distance in a depth direction of the first semiconductor region and the second semiconductor region is 1000 nm or less.

18. The light receiving element according to claim 1, wherein
an impurity concentration of each of the first semiconductor region and the second semiconductor region is 1E + 16/cm³ or more.

19. The light receiving element according to claim 1, wherein
the light receiving element has a stacked structure in which a first semiconductor substrate and a second semiconductor substrate are stacked,
the first semiconductor region and the second semiconductor region are formed in the first semiconductor substrate, and
a readout control circuit that controls signal reading of the pixel is formed on the second semiconductor substrate.

20. A distance measuring system comprising:
a lighting device that emits irradiation light; and
a light receiving element that receives reflected light obtained by reflecting the irradiation light by a subject, wherein
the light receiving element includes
a pixel in which a multiplication region is formed in a region where a first semiconductor region of a first conductivity type and a second semiconductor region of a second conductivity type opposite to the first semiconductor region are joined, and a planar region of the second semiconductor region formed at a position closer to a light receiving surface than the first semiconductor region is formed to be larger.
